(19) Europäisches Patentamt
European Patent Office
Office européen des brevets

(11) EP 3 783 043 A1

(12) EUROPEAN PATENT APPLICATION
published in accordance with Art. 153(4) EPC

(43) Date of publication:
24.02.2021 Bulletin 2021/08

(21) Application number: 19788855.5

(22) Date of filing: 17.04.2019

(51) Int Cl.:
*C08G 59/32* (2006.01) *B32B 15/092* (2006.01)
*C08J 5/24* (2006.01) *C08K 3/013* (2018.01)
*C08K 5/13* (2006.01) *C08L 63/00* (2006.01)
*H05K 1/03* (2006.01) *H05K 3/46* (2006.01)

(86) International application number:
PCT/JP2019/016553

(87) International publication number:
WO 2019/203291 (24.10.2019 Gazette 2019/43)

(84) Designated Contracting States:
AL AT BE BG CH CY CZ DE DK EE ES FI FR GB GR HR HU IE IS IT LI LT LU LV MC MK MT NL NO PL PT RO RS SE SI SK SM TR
Designated Extension States:
BA ME
Designated Validation States:
KH MA MD TN

(30) Priority: 20.04.2018 JP 2018081070

(71) Applicant: MITSUBISHI GAS CHEMICAL COMPANY, INC.
Chiyoda-ku
Tokyo 100-8324 (JP)

(72) Inventors:
- TADOKORO, Hiroaki
Tokyo 125-8601 (JP)
- YAMAGUCHI, Shohei
Tokyo 125-8601 (JP)
- TOMIZAWA, Katsuya
Tokyo 125-8601 (JP)
- KAWAI, Hidetoshi
Tokyo 125-8601 (JP)

(74) Representative: Hoffmann Eitle
Patent- und Rechtsanwälte PartmbB
Arabellastraße 30
81925 München (DE)

# (54) THERMOSETTING COMPOSITION, PREPREG, LAMINATE, METAL FOIL-CLAD LAMINATE, PRINTED WIRING BOARD, AND MULTILAYER PRINTED WIRING BOARD

(57) A thermosetting composition comprising at least a thermosetting compound, the thermosetting composition satisfying relationships represented by formulas (i) and (ii) below:

$$0.80 \leq b/a \leq 0.98 \cdots (i),$$

and

$$0.05 \leq c/a \leq 0.30 \cdots (ii),$$

wherein a, b, and c represent storage moduli (unit: GPa) at 30°C, 100°C, and 260°C, respectively, of a cured product formed by curing a prepreg obtained by impregnating or coating a base material with the thermosetting composition.



Printed by Jouve, 75001 PARIS (FR)

(Cont. next page)

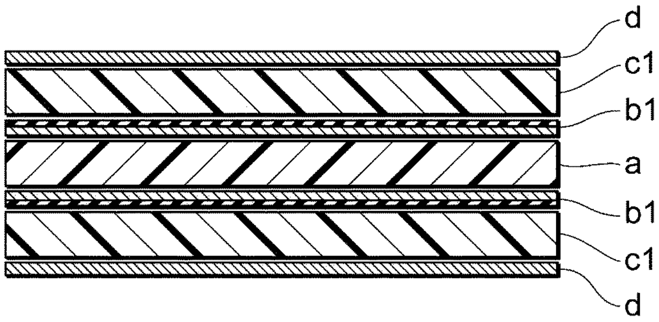


Fig.1

## Description

### Technical Field

The present invention relates to a thermosetting composition, a prepreg, a laminate, a metal foil-clad laminate, a printed wiring board, and a multilayer printed wiring board.

### Background Art

In recent years, high integration and high-density mounting of components for semiconductor packages have been accelerated more and more, with functionality enhancement and size reduction of semiconductor packages that are widely used for electronic devices, communication devices, personal computers, and the like. Along with this, various properties required for printed wiring boards for semiconductor packages are becoming more and more severe. Examples of the properties required for printed wiring boards include low water absorption, moisture absorption heat resistance, flame retardancy, low dielectric constant, low dielectric loss tangent, low coefficient of thermal expansion, heat resistance, chemical resistance, and high plating peel strength.

For example, Patent Literature 1 discloses a thermosetting composition containing an imidazole compound having a specific structure, an epoxy compound, a phenolic compound, and a maleimide compound for the purpose of satisfying low thermal expansion, high glass transition temperature, flame retardancy, and high degree of cure at the same time, even when cured at low temperature. In Examples of this literature, it is disclosed that a copper foil laminate formed using a prepreg obtained by impregnating and coating an E glass woven fabric with the aforementioned thermosetting composition has excellent low coefficient of thermal expansion, high glass transition temperature, flame retardancy, high degree of cure, high moisture absorption heat resistance, and high peel strength.

Patent Literature 2 discloses a laminate composed of a base material and a thermosetting composition wherein the thermosetting composition contains an epoxy resin with an aromatic ring skeleton, and the laminate has a linear expansion coefficient at a predetermined temperature within a predetermined range, a storage modulus at 30°C of 22 to 40 GPa, and a storage modulus at 180°C of 10 to 18 GPa, for the purpose of reducing warpage during the production process of multilayer printed wiring boards and the production process of semiconductor devices. This literature discloses that warpage in multilayer printed wiring boards is reduced by the linear expansion coefficient and the storage moduli at the predetermined temperatures falling within the aforementioned ranges, thereby reducing warpage in multilayer printed wiring board parts during the production process of semiconductor devices using the multilayer printed wiring boards. In Examples 1 to 6 of this literature, it is disclosed that a laminate (double-sided copper-clad laminate) having the aforementioned configuration has good low warpage before and after a reflow process.

### Citation List

### Patent Literature

Patent Literature 1: Japanese Patent Application Laid-Open No. 2014-37485
Patent Literature 2: Japanese Patent No. 5056787

### Summary of Invention

### Technical Problem

In recent years, it has become an important challenge to reduce warpage (package warpage) when producing electronic components (packages) using printed wiring boards (particularly, multilayer coreless boards). In order to overcome the aforementioned challenge, it is generally conceivable to reduce the difference in coefficient of thermal expansion between a printed wiring board and a semiconductor device to be mounted on the printed wiring board by reducing the coefficient of thermal expansion in the plane direction of the printed wiring board, as in Patent Literatures 1 and 2. However, it is still required to further reduce package warpage, even if the aforementioned methods are employed.

It is therefore an object of the present invention to provide a thermosetting composition, a prepreg, a laminate, a metal foil-clad laminate, a printed wiring board, and a multilayer printed wiring board that are capable of reducing warpage (package warpage) during the production of electronic components (packages).

Solution to Problem

As a result of diligent studies in order to overcome the aforementioned challenge, the inventors have found that, in a form of a cured product obtained by curing a prepreg, a thermosetting composition with a physical property parameter defined by a storage modulus at a predetermined temperature satisfying a predetermined range can reduce warpage (package warpage) during the production of electronic components (packages), thereby accomplishing the present invention.

That is, the present invention is as follows.

(1) A thermosetting composition comprising at least a thermosetting compound, the thermosetting composition satisfying relationships represented by formulas (i) and (ii) below: $0.80 \leq b/a \leq 0.98$ ··· (i), and $0.05 \leq c/a \leq 0.30$ ··· (ii), wherein a, b, and c represent storage moduli (unit: GPa) at 30°C, 100°C, and 260°C, respectively, of a cured product formed by curing a prepreg obtained by impregnating or coating a base material with the thermosetting composition.

(2) The thermosetting composition according to (1), further satisfying a relationship represented by formula (x) below: $100 \leq Tg \leq 220$ ··· (x), wherein Tg represents a glass transition temperature (unit: °C) of a cured product formed by curing a prepreg obtained by impregnating or coating a base material with the thermosetting composition.

(3) The thermosetting composition according to (1) or (2), further satisfying a relationship represented by formula (y) below: $D \geq 0.1$ ··· (y), wherein D represents a loss tangent of an elastic modulus at a glass transition temperature of a cured product formed by curing a prepreg obtained by impregnating or coating a base material with the thermosetting composition.

(4) The thermosetting composition according to any one of (1) to (3), wherein the thermosetting compound comprises a bifunctional thermosetting compound having bifunctionality and a polyfunctional thermosetting compound having tri- or higher functionality, a content of the bifunctional thermosetting compound is 40 to 90 parts by mass per 100 parts by mass of the solids of the thermosetting composition, and a content of the polyfunctional thermosetting compound is 10 to 50 parts by mass per 100 parts by mass of the solids of the thermosetting composition.

(5) The thermosetting composition according to (1) to (3), wherein the thermosetting compound comprises a bifunctional epoxy compound and a polyfunctional epoxy compound, a content of the bifunctional epoxy compound is 20 to 70 parts by mass per 100 parts by mass of the solids of the thermosetting composition, and a content of the polyfunctional epoxy compound is 10 to 50 parts by mass per 100 parts by mass of the solids of the thermosetting composition.

(6) The thermosetting compound according to (5), wherein at least one of the bifunctional epoxy compound and the polyfunctional epoxy compound comprises a naphthalene-type epoxy resin.

(7) The thermosetting composition according to any one of (1) to (6), wherein the thermosetting compound comprises a phenolic compound.

(8) The thermosetting composition according to (7), wherein the phenolic compound comprises a bifunctional phenolic compound, and a content of the bifunctional phenolic compound is 20 to 60 parts by mass per 100 parts by mass of the solids of the thermosetting composition.

(9)The thermosetting composition according to any one of (1) to (8), further comprising an inorganic filler, wherein a content of the inorganic filler is 30 parts by mass or more and 700 parts by mass or less per 100 parts by mass of the solids of the thermosetting composition.

(10) The thermosetting composition according to (9), wherein the inorganic filler is one or more selected from the group consisting of silica, boehmite, and alumina.

(11) The thermosetting composition according to any one of (1) to (10) for use in a metal foil-clad laminate.

(12) The thermosetting composition according to any one of (1) to (10) for use in a printed wiring board.

(13) The thermosetting composition according to any one of (1) to (10) for use in a multilayer printed wiring board.

(14) A prepreg comprising a base material and the thermosetting composition according to any one of (1) to (13), with which the base material is impregnated or coated.

(15) The prepreg according to (14), wherein the base material is composed of one or more glass fibers selected from the group consisting of E glass, D glass, S glass, T glass, Q glass, L glass, NE glass, and HME glass.

(16) A laminate comprising the prepreg according to (14) or (15).

(17) A metal foil-clad laminate comprising: the prepreg according to (14) or (15); and a metal foil disposed on one or each of both surfaces of the prepreg.

(18) A printed wiring board comprising an insulating layer formed using the prepreg according to (14) or (15); and a conductor layer formed on a surface of the insulating layer.

(19) A multilayer printed wiring board comprising: a plurality of insulating layers composed of a first insulating layer and one or a plurality of second insulating layers laminated on one side of the first insulating layer; and a plurality of conductor layers composed of a first conductor layer disposed between each two of the plurality of insulating

layers and a second conductor layer disposed on each of surfaces of outermost layers of the plurality of insulating layers, wherein the first insulating layer and the second insulating layer each comprise a cured product of the prepreg according to (14) or (15).

Advantageous Effects of Invention

The present invention can provide a thermosetting composition, a prepreg, a laminate, a metal foil-clad laminate, a printed wiring board, and a multilayer printed wiring board that are capable of reducing warpage (package warpage) during the production of electronic components (packages).

Brief Description of Drawings

[Figure 1] Figure 1 is a process flow diagram showing an example of a procedure to produce a panel of a multilayer coreless board (however, the method for producing a multilayer coreless board is not limited thereto: the same applies to Figure 2 to Figure 8 below).
[Figure 2] Figure 2 is a process flow diagram showing an example of a procedure to produce a panel of a multilayer coreless board.
[Figure 3] Figure 3 is a process flow diagram showing an example of a procedure to produce a panel of a multilayer coreless board.
[Figure 4] Figure 4 is a process flow diagram showing an example of a procedure to produce a panel of a multilayer coreless board.
[Figure 5] Figure 5 is a process flow diagram showing an example of a procedure to produce a panel of a multilayer coreless board.
[Figure 6] Figure 6 is a process flow diagram showing an example of a procedure to produce a panel of a multilayer coreless board.
[Figure 7] Figure 7 is a process flow diagram showing an example of a procedure to produce a panel of a multilayer coreless board.
[Figure 8] Figure 8 is a process flow diagram showing an example of a procedure to produce a panel of a multilayer coreless board.
[Figure 9] Figure 9 is a partial sectional view showing a configuration of an example of a panel of a multilayer coreless board.

Description of Embodiments

Hereinafter, an embodiment (hereinafter, referred to also as "this embodiment") for carrying out the present invention will be described in detail, but the present invention is not limited to this embodiment and can be variously modified without departing from the gist thereof.
The "solids of the thermosetting composition" as used herein refers to components excluding solvents and fillers in the thermosetting composition of this embodiment, and 100 parts by mass of the solids of the thermosetting composition means that the total amount of the components excluding solvents and fillers in the thermosetting composition is 100 parts by mass, unless otherwise specified.

[Thermosetting composition]

The thermosetting composition of this embodiment contains at least a thermosetting compound and satisfies the relationships represented by formulas (i) and (ii) below.

$$0.80 \leq b/a \leq 0.98 \cdots \text{(i)}$$

$$0.05 \leq c/a \leq 0.30 \cdots \text{(ii)}$$

In each formula, a, b, and c represent the storage moduli (unit: GPa) at 30°C, 100°C, and 260°C, respectively, of a cured product formed by curing a prepreg obtained by impregnating or coating a base material with the thermosetting

composition of this embodiment.

The thermosetting composition of this embodiment can reduce warpage (package warpage) during the production of electronic components (packages) by having the aforementioned configuration. The reason for this is considered as follows. Although the following description includes consideration, the present invention is not limited to this consideration.

First of all, the thermosetting composition of this embodiment in a cured form of a prepreg can sufficiently improve the glass transition temperature of the prepreg, mainly due to the ratio of the storage modulus at 100°C to the storage modulus at 30°C falling within a predetermined range (satisfying the relationship (i) above). As a result, the rigidity can be sufficiently ensured even with high temperature, and therefore the handleability (handling property) in the production process of printed wiring boards (particularly, thin boards such as multilayer coreless boards) can be improved.

Further, mainly due to the ratio of the storage modulus at 260°C to the storage modulus at 30°C falling within a predetermined range (satisfying the relationship (ii) above), viscous behavior can be expressed, for example, during a mounting step of mounting a semiconductor chip on a printed wiring board (particularly, a multilayer coreless board), as a result of which warpage (package warpage) during the production of electronic components (packages) can be reduced.

Further, the thermosetting composition of this embodiment can express viscous behavior during steps including heat treatment (such as a press forming step and an annealing step) by satisfying the relationship (ii) above and therefore can reduce warpage in metal foil-clad laminates, printed wiring boards, and multilayer printed wiring boards (particularly, multilayer coreless boards).

[Properties of thermosetting composition]

As described above, the thermosetting composition of this embodiment has physical property parameters, as defined by the storage moduli at predetermined temperatures, falling within predetermined ranges in a cured product formed by curing a prepreg obtained by impregnating or coating a base material (which will be hereinafter referred to simply as "cured product" or "cured product of the prepreg").

$$0.80 \leq b/a \leq 0.98 \cdots \text{(i)}$$

$$0.05 \leq c/a \leq 0.30 \cdots \text{(ii)}$$

In the formula, a, b, and c represent the storage moduli (unit: GPa) of the cured product at 30°C, 100°C, and 260°C, respectively.

The aforementioned prepreg may be a prepreg to be obtained by a known method. Specifically, the prepreg is obtained by impregnating or coating a base material with the thermosetting composition of this embodiment, followed by heat-drying at 100 to 200°C for semi-curing (into B stage). Here, the base material is not specifically limited and may be, for example, a known base material used for materials of various printed wiring boards. Further, the impregnating or coating method is not specifically limited, and a known method may be used.

The aforementioned cured product refers to a cured product obtained by thermosetting the prepreg at a heating temperature of 200 to 230°C for a heating time of 60 to 180 minutes. The pressure conditions for curing are also not specifically limited, as long as the actions and effects of the present invention are not inhibited, and conditions that are generally suitable for curing prepregs can be used. The heating device for curing the prepreg is also not specifically limited, as long as the actions and effects of the present invention are not inhibited, and general heating equipment (such as a dryer) may be used.

In formula (i), if b/a (the ratio of the storage modulus at 100°C to the storage modulus at 30°C) is 0.80 or more, the glass transition temperature of the prepreg can be sufficiently improved. As a result, the rigidity can be sufficiently ensured even with high temperature, and therefore the handleability (handling property) in the production process of printed wiring boards (particularly, thin boards such as multilayer coreless boards) can be improved. From the same point of view, b/a is preferably 0.85 or more, more preferably 0.90 or more, further preferably 0.94 or more.

In formula (ii), if c/a (the ratio of the storage modulus at 260°C to the storage modulus at 30°C) falls within the aforementioned range, viscous behavior can be expressed, for example, during a mounting step of mounting a semiconductor chip on a printed wiring board (particularly, a multilayer coreless board), as a result of which warpage (package warpage) during the production of electronic components (packages) can be reduced. From the same point of view, the lower limit of c/a is preferably 0.08 or more, more preferably 0.10 or more. The upper limit of c/a is preferably 0.25 or less, more preferably 0.20 or less, further preferably 0.18 or less.

The thermosetting composition of this embodiment preferably further satisfies the relationship represented by formula (iii) below.

$$15 < a \leq 30 \cdots (iii)$$

In formula (iii), if a (the storage modulus at 30°C) is over 15 GPa, there is a tendency that the rigidity can be sufficiently ensured. From the same point of view, a is more preferably 16 GPa or more, further preferably 18 GPa or more. Meanwhile, if a is 30 GPa or less, there is a tendency that warpage (package warpage) during the production of electronic components (packages) can be further reduced, and warpage in metal foil-clad laminates, printed wiring boards, and multilayer printed wiring boards (particularly, multilayer coreless boards) can be further reduced. From the same point of view, a is preferably 25 GPa or less, more preferably 23 GPa or less.

The thermosetting composition of this embodiment preferably further satisfies the relationship represented by formula (iv) and/or formula (v) below.

$$0.10 \leq d/a \leq 0.65 \cdots (iv)$$

$$0.05 \leq e/a \leq 0.25 \cdots (v)$$

In the formulas, d and e represent the storage moduli (unit: GPa) at 200°C, and 330°C, respectively, of a cured product formed by curing a prepreg obtained by impregnating or coating a base material with the thermosetting composition of this embodiment.

In formula (iv), if d/a (the ratio of the storage modulus at 200°C to the storage modulus at 30°C) falls within the aforementioned range, there is a tendency that viscous behavior can be expressed during steps including heat treatment (such as a press forming step and an annealing step), as a result of which warpage (package warpage) during the production of electronic components (packages) can be further reduced. From the same point of view, the lower limit of d/a is more preferably 0.14 or more, further preferably 0.16 or more, and the upper limit of d/a is more preferably 0.40 or less, further preferably 0.30 or less.

In formula (v), if e/a (the ratio of the storage modulus at 330°C to the storage modulus at 30°C) falls within the aforementioned range, there is a tendency that viscous behavior can be expressed during a mounting step of mounting a semiconductor chip on a printed wiring board (particularly, a multilayer coreless board), as a result of which warpage (package warpage) during the production of electronic components (packages) can be reduced. From the same point of view, the lower limit of e/a is more preferably 0.08 or more, further preferably 0.10 or more, and the upper limit of e/a is more preferably 0.22 or less, further preferably 0.16 or less.

The thermosetting composition of this embodiment preferably further satisfies the relationship represented by formula (x) below.

$$100 \leq Tg \leq 220 \cdots (x)$$

In the formula, Tg represents the glass transition temperature (unit: °C) of a cured product formed by curing a prepreg obtained by impregnating or coating a base material with the thermosetting composition of this embodiment.

Since the thermosetting composition of this embodiment can sufficiently ensure the rigidity even with high temperature by satisfying the relationship represented by formula (x), there is a tendency that the handleability (handling property) in the production process of printed wiring boards (particularly, thin boards such as multilayer coreless boards) can be further improved. From the same point of view, the lower limit of the glass transition temperature of the cured product is more preferably 130°C or more, further preferably 150°C or more, and the upper limit of the glass transition temperature of the cured product is more preferably 215°C or less, further preferably 210°C or less.

The thermosetting composition of this embodiment preferably further satisfies the relationship represented by formula (y) below.

$$D \geq 0.1 \cdots (y)$$

In the formula, D represents the loss tangent of the elastic modulus at the glass transition temperature of a

cured product formed by curing a prepreg obtained by impregnating or coating a base material with the thermosetting composition of this embodiment.

In formula (y), when D is a specific value or more, there is a tendency that warpage (package warpage) during the production of electronic components (packages) can be further reduced, and warpage in metal foil-clad laminates, printed wiring boards, and multilayer printed wiring boards (particularly, multilayer coreless boards) can be further reduced. From the same point of view, D is more preferably 0.12 or more (for example, 0.12 to 0.30), further preferably 0.14 or more.

The storage modulus, the glass transition temperature, and the loss tangent of the cured product can be measured by DMA (Dynamic Mechanical Analysis) according to JIS C6481. As a more detailed measurement method, a copper foil (3EC-VLP, available from MITSUI MINING & SMELTING CO., LTD., with a thickness of 12 μm) is first disposed on each of both top and bottom surfaces of one piece of the prepreg, followed by laminate formation (thermosetting) at a pressure of 30 $kgf/cm^2$ and a temperature of 220°C for 100 minutes, to obtain a copper foil-clad laminate with a predetermined thickness. Subsequently, the copper foil-clad laminate obtained is cut into a size of 5.0 mm × 20 mm using a dicing saw, and thereafter the copper foils on the surfaces are removed by etching, to obtain a measurement sample. The storage modulus, the glass transition temperature, and the loss tangent of the measurement sample obtained are measured using a dynamic viscoelasticity analyzer (available from TA Instruments Inc.). An arithmetic mean of three measured values is, for example, obtained as a measured value.

[Structural components]

As structural components, the thermosetting composition of this embodiment contains at least a thermosetting compound and may further contain inorganic fillers, silane coupling agents, wetting and dispersing agents, and curing accelerators.

(Thermosetting compound)

The thermosetting composition of this embodiment contains a thermosetting compound. The "thermosetting compound" as used herein refers to a compound that can be cured by heating. Examples of the thermosetting compound include a compound having at least one or more functional groups capable of proceeding with polymerization reaction or crosslinking reaction by heating between the same functional groups or different functional groups ("thermosetting functional groups") in a molecule. The thermosetting functional groups are not specifically limited, but examples thereof include phenolic hydroxyl groups, epoxy groups, cyanato groups (-O-C≡N), allyl groups, maleimide groups, alkenyl-substituted nadiimide groups, hydroxyl groups, amino groups, isocyanate groups, and other polymerizable unsaturated groups.

In this embodiment, the thermosetting compound preferably contains a bifunctional thermosetting compound having bifunctionality and a polyfunctional thermosetting compound having tri- or higher functionality. The "bifunctional thermosetting compound" as used herein refers to a compound having two thermosetting functional groups in one molecule (the number of thermosetting functional groups in one molecule is two), and the "polyfunctional thermosetting compound" as used herein refers to a compound having three or more thermosetting functional groups in one molecule (the number of thermosetting functional groups in one molecule is three or more). The thermosetting compound of this embodiment tends to have storage moduli during heating that is further suitable for suppressing package warpage by containing a bifunctional thermosetting compound having bifunctionality and a polyfunctional thermosetting compound. The thermosetting composition of this embodiment tends to have a further improved effect to reduce warpage (particularly, package warpage) particularly by containing a bifunctional thermosetting compound.

The reason why the storage moduli during heating become further suitable for suppressing package warpage by the thermosetting compound containing a bifunctional thermosetting compound and a polyfunctional thermosetting compound is considered as follows. However, the reason is not limited thereto. That is, there is a tendency that the thermosetting composition of this embodiment can further express viscous behavior during steps including heat treatment (such as a press forming step, an annealing step, and a mounting step), due to the thermosetting compound containing a bifunctional thermosetting compound. Meanwhile, there is a tendency that the thermosetting composition of this embodiment can sufficiently improve the glass transition temperature of the prepreg and therefore can sufficiently ensure the rigidity even with high temperature, as a result of which the thermosetting compound can further improve the handleability (handling property) in the production process of printed wiring boards (particularly, thin boards such as multilayer coreless boards) by containing a polyfunctional thermosetting compound. In this way, it is considered that the thermosetting compound of this embodiment can reduce warpage of packages and warpage of printed wiring boards during the production process by containing a bifunctional thermosetting compound and a polyfunctional thermosetting compound.

In the thermosetting compound of this embodiment, the content of the bifunctional thermosetting compound is

preferably 40 to 90 parts by mass per 100 parts by mass of the solids of the thermosetting composition. When the content falls within the aforementioned range, there is a tendency that the storage moduli during heating become further suitable for suppressing warpage (particularly, package warpage), as a result of which warpage of metal foil-clad laminates, printed wiring boards, and multilayer printed wiring boards (particularly multilayer coreless boards), and warpage (package warpage) during the production of electronic components (packages) can be further reduced. From the same point of view, the lower limit of the content is more preferably 55 parts by mass or more, and the upper limit of the content is more preferably 80 parts by mass or less, further preferably 68 parts by mass or less. The content of the bifunctional thermosetting compound can be determined, for example, by the method described in Examples below.

In the thermosetting compound of this embodiment, the content of the polyfunctional thermosetting compound is preferably 10 to 50 parts by mass per 100 parts by mass of the solids of the thermosetting composition. When the content falls within the aforementioned range, there is a tendency that the storage moduli during heating become further suitable for suppressing warpage (particularly, package warpage), as a result of which warpage of metal foil-clad laminates, printed wiring boards, and multilayer printed wiring boards (particularly multilayer coreless boards), and warpage (package warpage) during the production of electronic components (packages) can be further reduced. From the same point of view, the lower limit of the content is more preferably 15 parts by mass or more, further preferably 26 parts by mass or more, and the upper limit of the content is more preferably 45 parts by mass or less, further preferably 40 parts by mass or less. The content of the polyfunctional thermosetting compound can be determined, for example, by the method described in Examples below.

[Bifunctional epoxy compound and polyfunctional epoxy compound]

The thermosetting compound of this embodiment preferably contains a bifunctional epoxy compound and a trifunctional or higher polyfunctional epoxy compound. The "bifunctional epoxy compound" as used herein refers to a compound having two epoxy groups in one molecule (the number of epoxy groups in one molecule is two), and the "polyfunctional epoxy compound" as used herein refers to a compound having three or more epoxy groups in one molecule (the number of epoxy groups in one molecule is three or more). Further, such an "epoxy compound" as used herein may be in the form of a resin. When the thermosetting compound of this embodiment contains a bifunctional epoxy compound and a polyfunctional epoxy compound, there is a tendency that the storage moduli during heating become further suitable for suppressing warpage (particularly, package warpage), as a result of which warpage of metal foil-clad laminates, printed wiring boards, and multilayer printed wiring boards (particularly multilayer coreless boards), and warpage (package warpage) during the production of electronic components (packages) can be further reduced.

In the thermosetting compound of this embodiment, the content of the bifunctional epoxy compound is preferably 20 to 70 parts by mass per 100 parts by mass of the solids of the thermosetting composition. When the content falls within the aforementioned range, there is a tendency that the storage moduli during heating become further suitable for suppressing warpage (particularly, package warpage), as a result of which warpage of metal foil-clad laminates, printed wiring boards, and multilayer printed wiring boards (particularly multilayer coreless boards), and warpage (package warpage) during the production of electronic components (packages) can be further reduced. From the same point of view, the lower limit of the content is more preferably 22 parts by mass or more, and the upper limit of the content is more preferably 50 parts by mass or less, further preferably 38 parts by mass or less.

In the thermosetting compound of this embodiment, the content of the polyfunctional epoxy compound is preferably 10 to 50 parts by mass per 100 parts by mass of the solids of the thermosetting composition. When the content falls within the aforementioned range, there is a tendency that the storage moduli during heating become further suitable for suppressing warpage (particularly, package warpage), as a result of which warpage of metal foil-clad laminates, printed wiring boards, and multilayer printed wiring boards (particularly multilayer coreless boards), and warpage (package warpage) during the production of electronic components (packages) can be further reduced. From the same point of view, the lower limit of the content is more preferably 15 parts by mass or more, further preferably 20 parts by mass or more, and the upper limit of the content is more preferably 45 parts by mass or less, further preferably 40 parts by mass or less.

The epoxy compounds described above as the bifunctional epoxy compound and the polyfunctional epoxy compound are not specifically limited, but examples thereof include bisphenol-type epoxy resins (such as bisphenol A epoxy resins, bisphenol M epoxy resins, bisphenol E epoxy resins, bisphenol F epoxy resins, and bisphenol S epoxy resins), phenolic novolac epoxy resins (such as phenol novolac epoxy resins, bisphenol A novolac epoxy resins, and cresol novolac epoxy resins), aralkyl-type epoxy resins, biphenyl-type epoxy resins with a biphenyl skeleton, naphthalene-type epoxy resins with a naphthalene skeleton, anthracene-type epoxy resins with an anthracene skeleton, glycidyl ester-type epoxy resins, polyol-type epoxy resins, epoxy resins with an isocyanurate ring, dicyclopentadiene-type epoxy resins, fluorene-type epoxy resins with a fluorene skeleton, epoxy resins composed of bisphenol A structural units and hydrocarbon structural units, and their halogen compounds. One of these epoxy compounds may be used alone, or two or more of them may be used in combination. Whether one of these epoxy compounds is used alone, or two or more of

them are used in combination, it is preferable to contain a bifunctional epoxy compound and a polyfunctional epoxy compound, for exerting the actions and effects of the present invention effectively and reliably.

Among these, at least one of the bifunctional epoxy compound and the polyfunctional epoxy compound is preferably one or more selected from the group consisting of aralkyl-type epoxy resins, naphthalene-type epoxy resins, dicyclopentadiene-type epoxy resins, and epoxy resins composed of bisphenol A structural units and hydrocarbon structural units, and more preferably contains a naphthalene-type epoxy resin, for obtaining a cured product with further excellent heat resistance. Further, the epoxy compound preferably contains a bifunctional epoxy compound (preferably, a naphthalene-type epoxy resin), and a naphthalene-type epoxy resin with a naphthalene skeleton containing three or more epoxy groups in one molecule (preferably, a naphthylene ether-type epoxy resin containing three or more epoxy groups in one molecule) and/or a naphthalene aralkyl-type epoxy resin having three or more epoxy groups and a naphthalene ring in one molecule, as a polyfunctional epoxy compound, for exerting the actions and effects of the present invention effectively and reliably.

(Aralkyl-type epoxy resins)

Examples of the aralkyl-type epoxy resins include a compound represented by formula (3a) below.

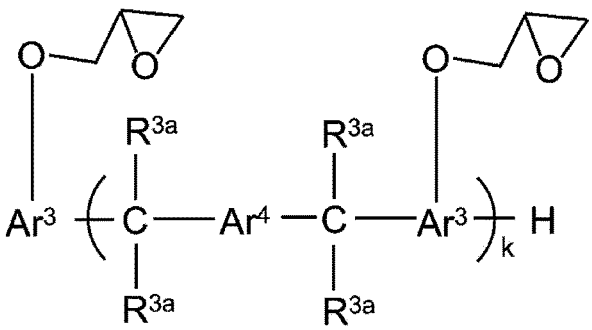

(3 a)

In formula (3a), each $Ar^3$ independently represents a benzene ring or a naphthalene ring, $Ar^4$ represents a benzene ring, a naphthalene ring, or a biphenyl ring, each $R^{3a}$ independently represents a hydrogen atom or a methyl group, k represents an integer of 1 to 50, and each ring may have a substituent other than a glycidyloxy group (such as an alkyl group having 1 to 5 carbon atoms or a phenyl group).

In formula (3a), k represents an integer of 1 to 50, preferably an integer of 1 to 10, preferably an integer of 1 to 6, more preferably an integer of 1 to 3, for exerting the actions and effects of the present invention effectively and reliably.

Such an aralkyl-type epoxy resin may contain a plurality of types of compounds with k being the same or a plurality of types of compounds with k being different, in the case of containing the compound represented by formula (3a). In the case of containing a plurality of types of compounds with k being different, the aralkyl-type epoxy resin preferably contains a compound with k being 1 to 3 in formula (3a).

In formula (3a), the compound represented by formula (3a) is preferably a compound with $Ar^3$ being a naphthalene ring and $Ar^4$ being a benzene ring (which is also referred to as "naphthalene aralkyl-type epoxy resin") and a compound with $Ar^3$ being a benzene ring and $Ar^4$ being a biphenyl ring (which is also referred to as "biphenylaralkyl-type epoxy resin"), more preferably a biphenylaralkyl-type epoxy resin, in that warpage (particularly, package warpage) can be further reduced.

The biphenylaralkyl-type epoxy resin is preferably a compound represented by formula (3b) below, for obtaining a cured product that is further excellent in heat resistance, low water absorption properties, and the effect to reduce warpage (particularly, package warpage).

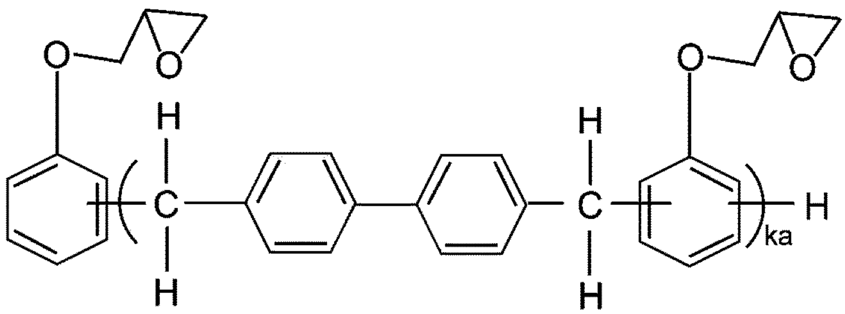

(3 b)

In formula (3b), ka represents an integer of 1 or more, preferably an integer of 1 to 6, more preferably an integer of 1 to 3.

Further, the aralkyl-type epoxy resin may be a compound represented by formula (3-a) or formula (3-b) below.

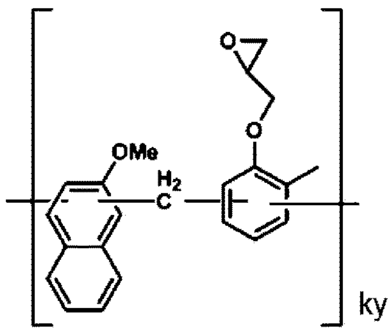

(3 − a)

In formula (3-a), ky represents an integer of 1 to 10.

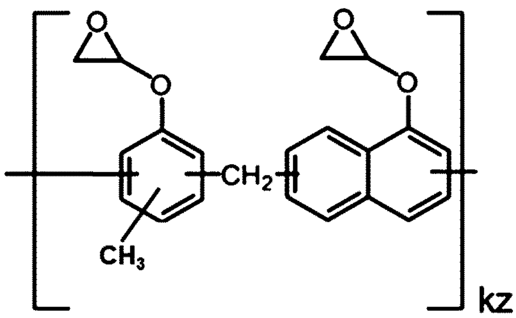

(3 − b)

In formula (3-b), kz represents an integer of 1 to 10.

The aralkyl-type epoxy resin to be used may be a commercially available product or a preparation prepared by a known method. Examples of the commercially available product of the naphthalene aralkyl-type epoxy resin include "Epotohto (R) ESN-155", " Epotohto (R) ESN-355", " Epotohto (R) ESN-375", " Epotohto (R) ESN-475V", " Epotohto (R) ESN-485", and " Epotohto (R) ESN-175", which are available from NIPPON STEEL & SUMIKIN CHEMICAL CO., LTD., "NC-7000", "NC-7300", and "NC-7300L", which are available from Nippon Kayaku Co., Ltd., and "HP-9900", "HP-9540", and "HP-9500", which are available from DIC Corporation. Examples of the commercially available product of the biphenylaralkyl-type epoxy resin include "NC-3000", "NC-3000L", and "NC-3000H", which are available from Nippon Kayaku Co., Ltd.

(Naphthalene-type epoxy resins)

The naphthalene-type epoxy resins are not specifically limited, but example thereof include epoxy resins with

a naphthalene skeleton excluding the aforementioned naphthalene aralkyl-type epoxy resins. Specific examples of the naphthalene-type epoxy resins include an epoxy resin represented by formula (3c-1) below and naphthylene ether-type epoxy resins. Naphthylene ether-type epoxy resins are preferable, for obtaining a cured product that is further excellent in heat resistance, low water absorption properties, and the effect to reduce warpage (particularly, package warpage).

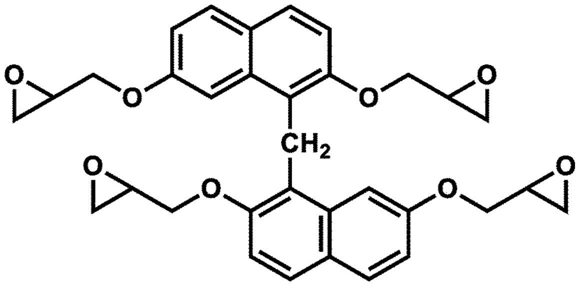

(3c-1)

The epoxy resin represented by (3c-1) above to be used may be a commercially available product or a preparation prepared by a known method. Examples of the commercially available product include "HP-4710" available from DIC Corporation.

(Naphthylene ether-type epoxy resins)

Examples of the naphthylene ether-type epoxy resins include a compound represented by formula (3c-2) below.

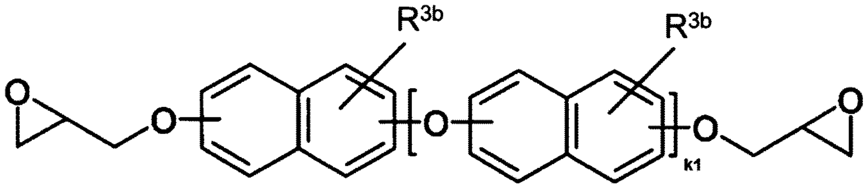

(3c-2)

In formula (3c-2), each $R^{3b}$ independently represents a hydrogen atom, an alkyl group having 1 to 5 carbon atoms, an aralkyl group, a benzyl group, a naphthyl group, or a naphthyl group containing a glycidyloxy group, and k1 represents an integer of 0 to 10.

In formula (3c-2), k1 represents an integer of 0 to 10, preferably an integer of 0 to 6, more preferably an integer of 0 to 4, particularly preferably an integer of 2 to 3, for exerting the actions and effects of the present invention effectively and reliably.

In formula (3c-2), each $R^{3b}$ preferably independently represents a hydrogen atom, an alkyl group having 1 to 5 carbon atoms, an aralkyl group, and a naphthyl group, for exerting the actions and effects of the present invention effectively and reliably.

In the compound represented by formula (3c-2), the number of the glycidyloxy groups containing an epoxy group is preferably 2 to 6, more preferably 2 to 4, in a molecule.

Such a naphthylene ether-type epoxy resin may contain a plurality of types of compounds with k1 being the same or a plurality of types of compounds with k1 being different, in the case of containing the compound represented by formula (3c-2). The naphthylene ether-type epoxy resin preferably contains a compound with k1 in formula (3c-2) being 0 to 4, more preferably 2 to 3, in the case of containing a plurality of types of compounds with k1 being different.

Examples of the compound represented by formula (3c-2) include a compound represented by formula (3c-3).

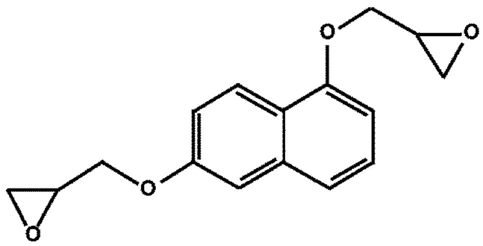

(3c-3)

The naphthylene ether-type epoxy resin to be used may be a commercially available product or a preparation prepared by a known method. Examples of the commercially available product of the naphthylene ether-type epoxy resin include "HP-4032", "HP-6000", "EXA-7300", "EXA-7310", "EXA-7311", "EXA-7311L", and "EXA7311-G3", which are available from DIC Corporation.

(Dicyclopentadiene-type epoxy resins)

Examples of the dicyclopentadiene-type epoxy resins include a compound represented by formula (3d) below.

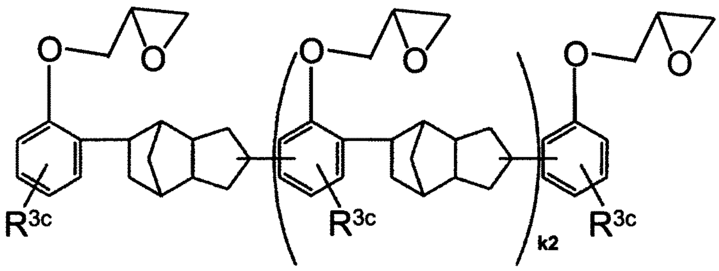

(3d)

In formula (3d), each $R^{3c}$ independently represents a hydrogen atom or an alkyl group having 1 to 5 carbon atoms, and k2 represents an integer of 0 to 10.

In formula (3d), k2 represents an integer of 0 to 10, preferably an integer of 0 to 6, preferably an integer of 0 to 2, for exerting the actions and effects of the present invention effectively and reliably.

Such a dicyclopentadiene-type epoxy resin may contain may contain a plurality of types of compounds with k2 being the same or may contain a plurality of types of compounds with k2 being different, in the case of containing the compound represented by formula (3d). The dicyclopentadiene-type epoxy resin preferably contains a compound with k2 being 0 to 2 in formula (3d) in the case of containing a plurality of types of compounds with k2 being different.

The dicyclopentadiene-type epoxy resin to be used may be a commercially available product or a preparation prepared by a known method. Examples of the commercially available product of the dicyclopentadiene-type epoxy resin include "EPICLON HP-7200L", "EPICLON HP-7200", "EPICLON HP-7200H", and "EPICLON HP-7000HH", which are available from DIC Corporation.

(Epoxy resins composed of bisphenol A structural units and hydrocarbon structural units)

Such an epoxy resin composed of bisphenol A structural units and hydrocarbon structural units (which is also referred to as "specific epoxy resin") has one or more bisphenol A structural units and one or more hydrocarbon structural units in a molecule. Examples of a specific epoxy resin include a compound represented by formula (3e) below.

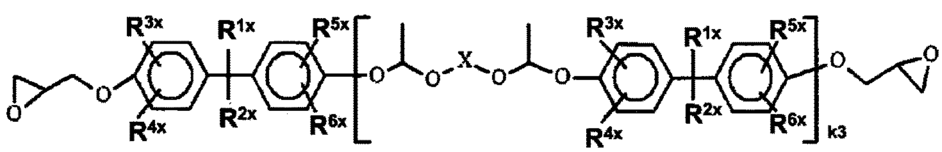

(3e)

In formula (3e), $R^{1x}$ and $R^{2x}$ each independently represent a hydrogen atom or a methyl group, $R^{3x}$ to $R^{6x}$ each independently represent a hydrogen atom, a methyl group, a chlorine atom, or a bromine atom, X represents an ethyleneoxyethyl group, a di(ethyleneoxy)ethyl group, a tri(ethyleneoxy)ethyl group, a propyleneoxypropyl group, a di(propyleneoxy)propyl group, a tri(propyleneoxy)propyl group, or an alkylene group having 2 to 15 carbon atoms, and k3 represents an integer.

In formula (3e), k3 represents an integer, preferably an integer of 1 to 10, more preferably an integer of 1 to 6, further preferably an integer of 1 to 2, particularly preferably 1, for exerting the actions and effects of the present invention effectively and reliably.

In formula (3e), X is preferably an ethylene group, for exerting the actions and effects of the present invention effectively and reliably.

The specific epoxy resin to be used may be a commercially available product or a preparation prepared by a known method. Examples of the commercially available product of the specific epoxy resin include "EPICLON EXA-4850-150" and "EPICLON EXA-4816", which are available from DIC Corporation.

The epoxy equivalent of the epoxy compound is preferably 100 to 500 g/eq or less, more preferably 400 g/eq or less, further preferably 350 g/eq or less. When the epoxy equivalent falls within the aforementioned range, there is a tendency that a cured product to be obtained has a glass transition temperature and storage moduli during heating that are further suitable for suppressing warpage (particularly, package warpage).

[Phenolic compound]

The thermosetting compound of this embodiment preferably contains a phenolic compound. The "phenolic compound" as used herein refers to a compound having two or more phenolic hydroxyl groups in one molecule, and the "compound" refers to a concept including resins. When the thermosetting compound of this embodiment contains a phenolic compound, there is a tendency that the storage moduli during heating become further suitable for suppressing warpage (particularly, package warpage), as a result of which warpage of metal foil-clad laminates, printed wiring boards, and multilayer printed wiring boards (particularly multilayer coreless boards), and warpage (package warpage) during the production of electronic components (packages) can be further reduced.

The phenolic compound is not specifically limited, as long as it is a compound having two or more phenolic hydroxyl groups in one molecule, and may be in the form of a resin. Examples of the phenolic compound include phenols having two or more phenolic hydroxyl groups in one molecule, bisphenol-type phenolic resins (such as bisphenol A resins, bisphenol E resins, bisphenol F resins, and bisphenol S resins), phenolic novolac resins (such as phenol novolac resins, naphthol novolac resins, and cresol novolac resins), naphthalene-type phenolic resins, anthracene-type phenolic resins, dicyclopentadiene-type phenolic resins, biphenyl-type phenolic resins, alicyclic phenolic resins, polyol-type phenolic resins, aralkyl-type phenolic resins, and phenol-modified aromatic hydrocarbon formaldehyde resins. One of these phenolic compounds may be used alone, or two or more of them may be used in combination.

Among these, the phenolic compound is preferably a bifunctional phenolic compound. The "bifunctional phenolic compound" as used herein refers to a compound having two phenolic hydroxyl groups in one molecule (the number of phenolic hydroxyl groups in one molecule is 2). When the phenolic compound contains a bifunctional phenolic compound, there is a tendency that the storage moduli during heating become further suitable for suppressing warpage (particularly, package warpage), as a result of which warpage of metal foil-clad laminates, printed wiring boards, and multilayer printed wiring boards (particularly multilayer coreless boards), and warpage (package warpage) during the production of electronic components (packages) can be further reduced.

The bifunctional phenolic compound is not specifically limited, but examples thereof include bisphenols, biscresols, bisphenols with a fluorene skeleton (such as bisphenols with a fluorene skeleton and biscresols with a fluorene skeleton), diallyl bisphenols (such as diallyl bisphenol A), biphenols (such as p,p'-biphenol), dihydroxydiphenylethers (such as 4,4'-dihydroxydiphenylether), dihydroxydiphenyl ketones (such as 4,4'-dihydroxydiphenylether), dihydroxydiphenyl sulfides (such as 4,4'-dihydroxydiphenyl sulfide), and dihydroxyarenes (such as hydroquinone). One of these bifunctional phenolic compounds may be used alone, or two or more of them may be used in combination. Among these, the bifunctional phenolic compound is preferably a bisphenol, a biscresol, or a bisphenol with a fluorene skeleton, for further improving the effect to reduce warpage (particularly, package warpage).

Examples of the bisphenol include bisphenol A, bisphenol M, bisphenol E, bisphenol F, bisphenol AD, bisphenol B, bisphenol AP, bisphenol S, bisphenol Z, and bisphenol TMC. One of these bisphenols may be used alone, or two or more of them may be used in combination. Among these, the bisphenol is preferably bisphenol A or bisphenol M, for further improving the effect to reduce warpage (particularly, package warpage).

The phenol equivalent of the phenolic compound (the hydroxyl equivalent of phenolic hydroxyl groups) is preferably 500 g/eq or less (such as 100 to 500 g/eq), more preferably 400 g/eq or less, further preferably 350 g/eq or less. When the phenol equivalent falls within the aforementioned range, there is a tendency that a cured product to be obtained has a glass transition temperature and storage moduli during heating that are further suitable for suppressing warpage (particularly, package warpage).

In the thermosetting compound of this embodiment, the content of the bifunctional phenolic compound is preferably 20 to 60 parts by mass per 100 parts by mass of the solids of the thermosetting composition. When the content falls within the aforementioned range, there is a tendency that the storage moduli during heating become further suitable for suppressing warpage (particularly, package warpage), as a result of which warpage of metal foil-clad laminates, printed wiring boards, and multilayer printed wiring boards (particularly multilayer coreless boards), and warpage (package warpage) during the production of electronic components (packages) can be further reduced in the thermosetting composition of this embodiment. From the same point of view, the lower limit of the content is more preferably 25 parts by mass or more, further preferably 30 parts by mass or more, and the upper limit of the content is more preferably 50 parts by mass or less, further preferably 45 parts by mass or less.

When the thermosetting compound of this embodiment contains epoxy compounds and phenolic compounds, the total content of epoxy compounds and phenolic compounds is preferably 50 parts by mass or more, more preferably 60 parts by mass or more, further preferably 70 parts by mass or more, particularly preferably 80 parts by mass or more (preferably, 85 parts by mass or more, more preferably 90 parts by mass or more), per 100 parts by mass of the solids of the thermosetting composition. When the total content falls within the aforementioned range, there is a tendency that the storage moduli during heating become further suitable for suppressing warpage (particularly, package warpage).

When the thermosetting composition contains phenolic compounds and epoxy compounds, the ratio of the epoxy equivalent to the phenol equivalent is preferably 0.5 to 1.5. When the ratio falls within the aforementioned range, there is a tendency that the storage moduli during heating become further suitable for suppressing warpage (particularly, package warpage). From the same point of view, the lower limit of the ratio is preferably 0.5 or more, more preferably 0.6 or more, further preferably 0.7 or more, and the upper limit of the ratio is preferably 1.5 or less, more preferably 1.4 or less, further preferably 1.3 or less.

When the resin composition contains phenolic compounds and/or cyanate compounds and epoxy compounds, the ratio of the amount of phenol groups (content parts by mass/phenol equivalent) and/or the amount of cyanate ester groups (content parts by mass/cyanate ester equivalent) in the resin composition to the amount of epoxy groups (content parts by mass/epoxy equivalent) in the resin composition is preferably 0.5 to 1.5. When the resin composition contains both phenolic compounds and cyanate compounds, the aforementioned ratio is the ratio of the total amount of phenol groups and cyanate groups to the amount of epoxy groups. When the ratio falls within the aforementioned range, the storage moduli during heating tend to be suitable for suppressing warpage. From the same point of view, the lower limit of the ratio is preferably 0.5 or more, more preferably 0.6 or more, further preferably 0.7 or more, particularly preferably 0.9 or more, and the upper limit of the ratio is preferably 1.5 or less, more preferably 1.4 or less, further preferably 1.3 or less, particularly preferably 1.2 or less. When a plurality of types of phenolic compounds are contained, the amount of phenol groups refers to the total amount of phenol groups of the phenolic compounds. When a plurality of types of cyanate compounds are contained, the amount of cyanate groups refers to the total amount of cyanate groups of the cyanate compounds. When a plurality of types of epoxy compounds are contained, the amount of epoxy groups refers to the total amount of epoxy groups of the epoxy compounds.

[Other thermosetting compounds]

The thermosetting compound of this embodiment may contain other thermosetting compounds. Examples of the other thermosetting compounds include cyanate compounds, allyl group-containing compounds, maleimide compounds, and alkenyl-substituted nadiimide compounds. One of these thermosetting compounds may be used alone, or two or more of them may be used in combination.

(Cyanate compound)

The thermosetting compound may contain a cyanate compound. The "cyanate compound" as used herein refers to a compound having one or more cyanato groups (cyanate ester groups) in one molecule, and the "compound" refers to a concept including resins. Examples of the cyanate compound include an aromatic hydrocarbon compound containing two or more cyanato groups in one molecule, a compound in which two aromatic rings containing two or more cyanato groups are bound by a linking group, novolac cyanate esters, bisphenol-type cyanate esters, diallyl bisphenol-type cyanate esters (such as diallyl bisphenol A cyanate esters, diallyl bisphenol F cyanate esters, diallyl bisphenol F cyanate esters, and diallyl bisphenol S cyanate esters), aralkyl-type cyanate esters, and prepolymers of these cyanate esters. One of these cyanate compounds may be used alone, or two or more of them may be used in combination.

Examples of the aromatic hydrocarbon compound having two or more cyanato groups in one molecule include a compound represented by formula (I): $Ar\text{-}(OCN)_p$, wherein Ar represents any one of a benzene ring, a naphthalene ring, and a biphenyl ring, and p represents an integer of 2 or more. In formula (I), the compound with p being 2 is not specifically limited, but examples thereof include 1,3-dicyanatobenzene, 1,4-dicyanatobenzene, 1,3,5-tricyanatobenzene, 1,3-dicyanatonaphthalene, 1,4-dicyanatonaphthalene, 1,6-dicyanatonaphthalene, 1,8-dicyanatonaphthalene, 2,6-dicyanatonaphthalene, 2,7-dicyanatonaphthalene, 1,3,6-tricyanatonaphthalene, and 4,4'-dicyanatobiphenyl.

The compound in which two aromatic rings containing two or more cyanato groups are bound by a linking group is not specifically limited, but example thereof include bis(4-cyanatophenyl)ether, bis(4-cyanatophenyl)thioether, and bis(4-cyanatophenyl)sulfone.

Examples of the novolac cyanate esters include a compound represented by formula (1x) below.

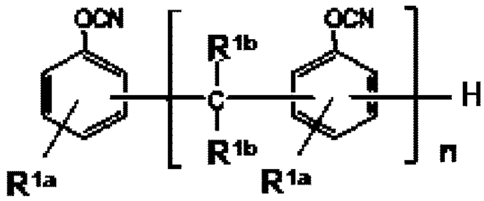

(1 x)

In formula (1x), each $R^{1a}$ independently represents a hydrogen atom or an alkyl group having 1 to 5 carbon atoms, each $R^{1b}$ independently represents a hydrogen atom or a methyl group (preferably, a hydrogen atom), and n represents an integer of 1 to 10.

In formula (1x), n represents an integer of 1 to 10, preferably an integer of 1 to 6, for exerting the actions and effects of the present invention effectively and reliably.

Such a novolac cyanate ester may contain a plurality of types of compounds with n being the same or may contain a plurality of types of compounds with n being different, in the case of containing the compound represented by formula (1x).

The compound represented by formula (1x) is not specifically limited, but example thereof include bis(3,5-dimethyl 4-cyanatophenyl)methane, bis(4-cyanatophenyl)methane, and 2,2'-bis(4-cyanatophenyl)propane.

(Bisphenol-type cyanate esters)

The bisphenol-type cyanate esters are not specifically limited, but example thereof include a compound in which a hydrogen atom in the phenolic hydroxyl group of the bisphenols described for the phenolic compounds is substituted with a cyan group (-C≡N). Specifically, examples thereof include bisphenol A cyanate esters, bisphenol E cyanate esters, bisphenol F cyanate esters, bisphenol AD cyanate esters, bisphenol B cyanate esters, bisphenol AP cyanate esters, bisphenol S cyanate esters, bisphenol Z cyanate esters, and bisphenol TMC cyanate esters.

Such a bisphenol-type cyanate ester to be used may be a commercially available product or a preparation prepared by a known method. Examples of the commercially available product of the bisphenol-type cyanate ester include "CA210", available from MITSUBISHI GAS CHEMICAL COMPANY, INC.

(Aralkyl-type cyanate esters)

The aralkyl-type cyanate esters are not specifically limited, but example thereof include naphthol aralkyl-type cyanate esters and biphenylaralkyl-type cyanate esters.

Examples of the naphthol aralkyl-type cyanate esters include a compound represented by formula (1a) below.

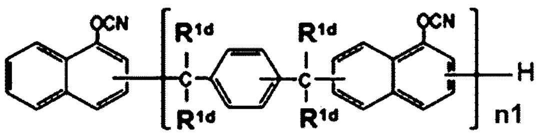

(1 a)

In formula (1a), each $R^{1d}$ independently represents a hydrogen atom or a methyl group (preferably, a hydrogen atom), and n1 represents an integer of 1 to 10.

In formula (1a), n1 represents an integer of 1 to 10, preferably an integer of 1 to 6, for exerting the actions and effects of the present invention effectively and reliably.

Such an aralkyl-type cyanate ester may contain a plurality of types of compounds with n1 being the same or may contain a plurality of types of compounds with n1 being different, in the case of containing the compound represented by formula (1a).

Examples of the biphenylaralkyl-type cyanate esters include a compound represented by formula (1b) below.

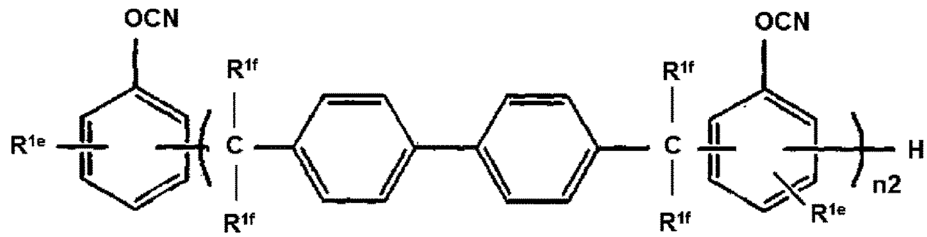

(1 b)

In formula (1b), each $R^{1e}$ independently represents a hydrogen atom or an alkyl group having 1 to 5 carbon atoms, each $R^{1f}$ independently represents a hydrogen atom or a methyl group (preferably, a hydrogen atom), and n2 represents an integer of 1 to 10.

In formula (1b), n2 represents an integer of 1 to 10, preferably an integer of 1 to 6, for exerting the actions and effects of the present invention effectively and reliably.

Such a biphenylaralkyl-type cyanate ester may contain a plurality of types of compounds with n2 being the same or may contain a plurality of types of compounds with n2 being different, in the case of containing the compound represented by formula (1b).

The aralkyl-type cyanate ester to be used may be a commercially available product or a product synthesized by a known method. Examples of the method for synthesizing an aralkyl-type cyanate ester include a method of reacting a phenolic resin corresponding to a desired aralkyl-type cyanate ester (which will be hereinafter referred to as "corresponding phenolic resin"), a cyanogen halide, and a basic compound in an inert organic solvent, and a method of allowing a two-phase interfacial reaction between a cyanogen halide and a salt formed by reacting a corresponding phenolic resin and a basic compound in an aqueous solution. In either method, an aralkyl-type cyanate ester can be obtained by cyanating the hydrogen atom of the phenolic hydroxyl group of the corresponding phenolic resin. More specifically, the method described in Examples or the like is used, for example.

The content of the cyanate compound may be, for example, 0 to 45 parts by mass, preferably 35 parts by mass or less, more preferably 25 parts by mass or less, further preferably 15 parts by mass or less, particularly preferably 5 parts by mass or less, per 100 parts by mass of the solids of the thermosetting composition, for exerting the actions and effects of the present invention effectively and reliably.

(Maleimide compound)

The thermosetting compound may further contain a maleimide compound. The "maleimide compound" as used herein refers to a compound having one or more maleimide groups in one molecule, and may be in the form of a resin. The maleimide compound is not specifically limited, as long as it is a compound having one or more maleimide groups in one molecule, but examples thereof include monomaleimide compounds having one maleimide group in one molecule (such as N-phenyl maleimide and N-hydroxyphenyl maleimide), polymaleimide compounds having two or more maleimide groups in one molecule (such as bis(4-maleimidephenyl)methane, bis(3,5-dimethyl-4-maleimidephenyl)methane, bis(3-ethyl-5-methyl-4-maleimidephenyl)methane, and bis(3,5-diethyl-4-maleimidephenyl)methane), and prepolymers of these maleimide compounds with amine compounds. One of these maleimide compounds may be used alone, or two or more of them may be used in combination.

Examples of the polymaleimide compound include compounds with a plurality of maleimide groups bound to a benzene ring (such as phenylenebismaleimides, including m-phenylenebismaleimide, and 4-methyl-1,3-phenylenebismaleimide), compounds with maleimide groups bound to both ends of a linear or branched alkyl chain (such as 1,6-bismaleimide-(2,2,4-trimethyl)hexane), bisphenol A diphenyl ether bismaleimide, and a compound represented by formula (4a) below.

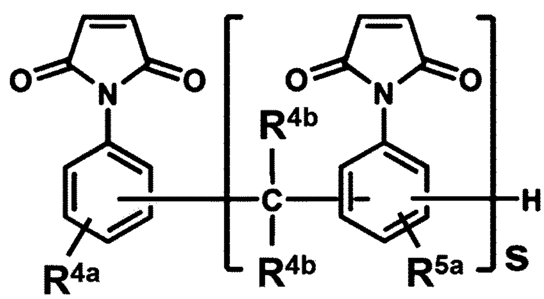

(4 a)

In the formula, $R^{4a}$ and $R^{5a}$ each independently represent a hydrogen atom or an alkyl group having 1 to 5 carbon atoms, preferably a hydrogen atom, each $R^{4b}$ independently represents a hydrogen atom or a methyl group, preferably a hydrogen atom, for exerting the actions and effects of the present invention effectively and reliably, and s represents an integer of 1 or more.

Specific examples of the compound represented by formula (4a) include bis(4-maleimidephenyl)methane, 2,2-bis{4-(4-maleimide phenoxy)-phenyl}propane, and bis(3-ethyl-5-methyl-4-maleimidephenyl)methane. When the polymaleimide compound contains the maleimide compound represented by formula (4a), a cured product to be obtained tends to have a further reduced coefficient of thermal expansion, a further improved heat resistance, and a further improved glass transition temperature (Tg). One of these maleimide compounds may be used alone, or two or more of them may be used in combination.

The maleimide compound to be used may be a commercially available product or a preparation prepared by a known method. Examples of the commercially available product of the maleimide compound include "BMI-70" and "BMI-80", which are available from K. I Chemical Industry Co., Ltd., and "BMI-1000P", "BMI-3000", "BMI-4000", "BMI-5100", "BMI-7000", and "BMI-2300", which are available from Daiwa Kasei Industry Co., Ltd.

The content of the maleimide compound may be, for example, 0 to 45 parts by mass, preferably 35 parts by mass or less, more preferably 25 parts by mass or less, further preferably 15 parts by mass or less, particularly preferably 5 parts by mass or less, per 100 parts by mass of the solids of the thermosetting composition, for exerting the actions and effects of the present invention effectively and reliably.

(Alkenyl-substituted nadiimide compound)

The thermosetting compound may further contain an alkenyl-substituted nadiimide compound. The "alkenyl-substituted nadiimide compound" as used herein refers to a compound having one or more alkenyl-substituted nadiimide groups in a molecule. Examples of the alkenyl-substituted nadiimide compound include a compound represented by formula (5a) below.

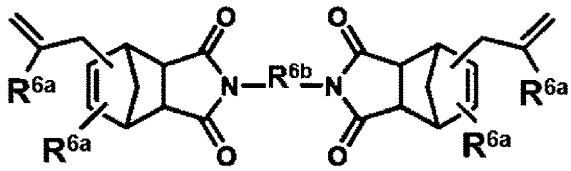

(5a)

In formula (5a), each $R^{6a}$ independently represents a hydrogen atom or an alkyl group having 1 to 6 carbon atoms, $R^{6b}$ represents an alkylene group having 1 to 6 carbon atoms, a phenylene group, a biphenylene group, a naphthylene group, or a group represented by formula (5b) or (5c) below.

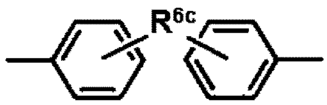

(5b)

In formula (5b), $R^{6c}$ represents a methylene group, an isopropylidene group, or a substituent represented by CO, O, S, or $SO_2$.

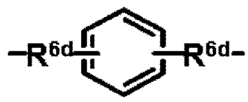

(5c)

In formula (5c), each $R^{6d}$ independently represents an alkylene group having 1 to 4 carbon atoms or a cycloalkylene group having 5 to 8 carbon atoms.

Further, examples of the alkenyl-substituted nadiimide compound also include a compound represented by formula (12) and/or (13) below.

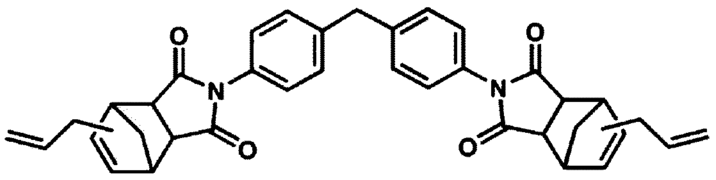

(12)

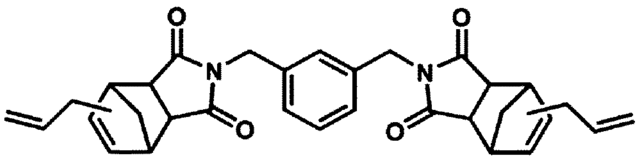

(13)

The alkenyl-substituted nadiimide compound to be used may be a commercially available product or a preparation prepared by a known method. The commercially available product of the alkenyl-substituted nadiimide compound is not specifically limited, but example thereof include "BANI-M" and "BANI-X", which are available from Maruzen Petrochemical Co., Ltd.

The alkenyl-substituted nadiimide compound preferably includes a bifunctional alkenyl-substituted nadiimide compound. The "bifunctional alkenyl-substituted nadiimide compound" as used herein refers to a compound having two alkenyl-substituted nadiimide groups in one molecule (the number of alkenyl-substituted nadiimide groups in one molecule is 2).

The content of the alkenyl-substituted nadiimide compound may be, for example, 0 to 45 parts by mass, preferably 35 parts by mass or less, more preferably 25 parts by mass or less, further preferably 15 parts by mass or less, particularly preferably 5 parts by mass or less, per 100 parts by mass of the solids of the thermosetting composition, for exerting the actions and effects of the present invention effectively and reliably.

The thermosetting composition of this embodiment may or may not contain an elastomer (such as acrylic rubber, silicone rubber, and core shell rubber) for reducing the elastic modulus at a predetermined temperature of the cured product. The elastomer is not included in the thermosetting compound.

The content of the elastomer is, for example, less than 30 parts by mass, preferably 25 parts by mass or less, more preferably 20 parts by mass or less, further preferably 15 parts by mass or less, particularly preferably 10 parts by mass or less (preferably 5 parts by mass or less, more preferably 0 parts by mass), per 100 parts by mass of the solids of the thermosetting composition. When the content is a specific value or less, there is a tendency that the heat resistance of a cured product to be obtained can be further improved. Here, the "solids of the thermosetting composition" refer to components excluding solvents, fillers, and elastomers, and 100 parts by mass of the solids of the thermosetting composition means that the total of components excluding solvents, fillers, and elastomers in the thermosetting composition is 100 parts by mass.

The thermosetting composition of this embodiment may contain other resins described below, as long as the actions and effects of the present invention are not inhibited. Examples of the other resins include compounds having a polymerizable unsaturated group, oxetane resins, and benzoxazine compounds. Examples of the compounds having a polymerizable unsaturated group include vinyl compounds such as ethylene, propylene, styrene, divinylbenzene, and divinylbiphenyl; (meth)acrylates of mono- or polyhydric alcohols such as methyl(meth)acrylate, 2-hydroxyethyl(meth)acrylate, 2-hydroxypropyl(meth)acrylate, polypropylene glycol di(meth)acrylate, trimethylolpropane di(meth)acrylate, trimethylolpropane tri(meth)acrylate, pentaerythritol tetra(meth)acrylate, and dipentaerythritol hexa(meth)acrylate; epoxy (meth)acrylates such as bisphenol A epoxy (meth)acrylates and bisphenol F epoxy (meth)acrylates; and benzocyclobutene resins. Examples of the oxetane resins include oxetane, alkyloxetanes such as 2-methyloxetane, 2,2-dimethyloxetane, 3-methyloxetane, and 3,3-dimethyloxetane, 3-methyl-3-methoxymethyloxetane, 3,3'-di(trifluoromethyl)perfluoxetane, 2-chloromethyloxetane, 3,3-bis(chloromethyl)oxetane, biphenyl-type oxetane, and "OXT-101" and "OXT-121", which are available from TOAGOSEI CO., LTD. The benzoxazine compounds need only to be compounds having two or more dihydrobenzoxazine rings in one molecule, and examples thereof include "bisphenol F benzoxazine BF-BXZ" and "bisphenol S benzoxazine BS-BXZ", which are available from Konishi Chemical Ind. Co., Ltd.

[Filler]

The thermosetting composition of this embodiment may further contain a filler. Examples of the filler include inorganic fillers and/or organic fillers.

The inorganic fillers are not specifically limited, and examples thereof include silica, silicon compounds (such as white carbon), metal oxides (such as alumina, titanium white, zinc oxide, magnesium oxide, and zirconium oxide),

metal nitrides (such as boron nitride, aggregated boron nitride, silicon nitride, and aluminum nitride), metal sulfates (such as barium sulfate), metal hydroxides (such as aluminum hydroxide, heat-treated products of aluminum hydroxide, e.g., aluminum hydroxide heat-treated to partially reduce crystal water, boehmite, and magnesium hydroxide), molybdenum compounds (such as molybdenum oxide and zinc molybdate), zinc compounds (such as zinc borate and zinc stannate), clay, kaolin, talc, firing clay, firing kaolin, firing talc, mica, E-glass, A-glass, NE-glass, C-glass, L-glass, D-glass, S-glass, M-glass G20, glass short fibers (including glass fine powders such as E glass, T glass, D glass, S glass, and Q glass), hollow glass, and spherical glass. One of these inorganic fillers may be used alone, or two or more of them may be used in combination. Among these, the filler is preferably at least one selected from the group consisting of silica, metal hydroxides, and metal oxides, more preferably at least one selected from the group consisting of silica, boehmite, and alumina, further preferably silica, from the viewpoint of being further excellent in low thermal expansion, dimensional stability, flame retardancy, rigidity, and reduction of warpage (particularly, package warpage).

Examples of the silica include natural silica, fused silica, synthetic silica, amorphous silica, aerosil, and hollow silica. Among these, fused silica is preferable from the viewpoint of being further excellent in low thermal expansion, rigidity, and reduction of warpage (particularly, package warpage).

Examples of the organic fillers include rubber powders such as styrene powder, butadiene powder, and acrylic powder; core shell rubber powders; and silicone powders. One of these organic fillers may be used alone, or two or more of them may be used in combination. Among these, silicone powders are preferable from the viewpoint of being further excellent in low thermal expansion, flexibility, and reduction of warpage (particularly, package warpage).

Examples of the silicone powders include silicone resin powder, silicone rubber powder, and silicone composite powder. Among these, silicone composite powder is preferable from the viewpoint of being further excellent in low thermal expansion, flexibility, and reduction of warpage (particularly, package warpage).

The filler of this embodiment preferably contains an inorganic filler and an organic filler from the viewpoint of being further excellent in low thermal expansion, dimensional stability, flexibility, rigidity, and reduction of warpage (particularly, package warpage).

The content of the inorganic filler is preferably 30 parts by mass or more and 700 parts by mass or less per 100 parts by mass of the solids of the thermosetting composition. When the content is 30 parts by mass or more, a cured product to be obtained tends to have further improved low thermal expansion. When the content is 700 parts by mass or less, a cured product to be obtained tends to have further improved drillability. From the same point of view, the lower limit of the content is preferably 30 parts by mass or more, more preferably 35 parts by mass or more, further preferably 40 parts by mass or more, and may be 50 parts by mass or more or 90 parts by mass or more. From the same point of view, the upper limit of the content is preferably 700 parts by mass or less, more preferably 600 parts by mass or less, further preferably 500 parts by mass or less, particularly preferably 250 parts by mass or less, and may be 200 parts by mass or less.

When the thermosetting composition contains an organic filler, the content of the organic filler is preferably 1 part by mass or more and 50 parts by mass or less per 100 parts by mass of the solids of the thermosetting composition from the viewpoint of being further excellent in low thermal expansion, flexibility, and reduction of warpage (particularly, package warpage). From the same point of view, the lower limit of the content is preferably 1 part by mass or more, more preferably 5 parts by mass or more, and may be 10 parts by mass or more. The upper limit of the content is preferably 50 parts by mass or less, more preferably 40 parts by mass or less, further preferably 30 parts by mass or less.

The content of the filler is preferably 40 parts by mass or more and 700 parts by mass or less per 100 parts by mass of the solids of the thermosetting composition from the viewpoint of being further excellent in low thermal expansion, dimensional stability, flexibility, rigidity, and reduction of warpage (particularly, package warpage). From the same point of view, the lower limit of the content is preferably 40 parts by mass or more, more preferably 45 parts by mass or more, and may be 50 parts by mass or more. The upper limit of the content is preferably 700 parts by mass or less, more preferably 600 parts by mass or less, further preferably 500 parts by mass or less, particularly preferably 250 parts by mass or less.

[Silane coupling agent]

The thermosetting composition of this embodiment may further contain a silane coupling agent. When the thermosetting composition of this embodiment contains a silane coupling agent, there is a tendency that the dispersibility of the filler is further improved, and the adhesion strength of the components of the thermosetting composition of this embodiment to a base material, which will be described below is further improved.

Examples of the silane coupling agent include silane coupling agents generally used for surface treatment of inorganic substances, including aminosilane compounds (such as γ-aminopropyltriethoxysilane and N-β-(aminoethyl)-γ-aminopropyltrimethoxysilane), epoxysilane compounds (such as γ-glycidoxypropyltrimethoxysilane), acrylic silane compounds (such as γ-acryloxy propyltrimethoxysilane), cationic silane compounds (such as N-β-(N-vinylbenzylaminoethyl)-γ-aminopropyltrimethoxysilane hydrochloride), and phenylsilane compounds. One of these silane coupling

agents may be used alone, or two or more of them may be used in combination. Among these, the silane coupling agent is preferably an epoxysilane compound. Examples of the epoxysilane compound include "KBM-403", "KBM-303", "KBM-402", and "KBE-403", which are available from Shin-Etsu Chemical Co., Ltd.

The content of the silane coupling agent may be about 0.1 to 10.0 parts by mass per 100 parts by mass of the solids of the thermosetting composition.

[Wetting and dispersing agent]

The thermosetting composition of this embodiment may further contain a wetting and dispersing agent. When the thermosetting composition of this embodiment contains a wetting and dispersing agent, the dispersibility of the filler tends to be further improved.

The wetting and dispersing agent may be a known dispersant (dispersion stabilizer) used for dispersing fillers, and examples thereof include DISPER BYK-110, 111, 118, 180, 161, BYK-W996, W9010, and W903, which are available from BYK Japan KK.

The content of the wetting and dispersing agent is preferably 0.5 parts by mass or more and 5.0 parts by mass or less per 100 parts by mass of the solids of the thermosetting composition. When the content falls within the aforementioned range, there is a tendency that the dispersibility of the filler can be further improved. From the same point of view, the lower limit of the content is preferably 0.5 parts by mass or more, more preferably 1.0 part by mass or more, further preferably 1.5 parts by mass or more.

[Curing accelerator]

The thermosetting composition of this embodiment may further contain a curing accelerator. Examples of the curing accelerator include imidazoles (such as triphenylimidazole), organic peroxides (such as benzoylperoxide, lauroylperoxide, acetylperoxide, parachlorobenzoylperoxide, and di-tert-butyl-di-perphthalate), azo compounds (such as azobisnitrile), tertiary amines (such as N,N-dimethylbenzylamine, N,N-dimethylaniline, N,N-dimethyltoluidine, N,N-dimethylpyridine, 2-N-ethylanilino ethanol, tri-n-butylamine, pyridine, quinoline, N-methylmorpholine, triethanolamine, triethylenediamine, tetramethylbutanediamine, and N-methylpiperidine), organic metal salts (such as lead naphthenate, lead stearate, zinc naphthenate, zinc octylate, tin oleate, dibutyltin malate, manganese naphthenate, cobalt naphthenate, and acetylacetone iron), the above organic metal salts dissolved in hydroxyl group-containing compounds such as phenol and bisphenol, inorganic metal salts (such as tin chloride, zinc chloride, and aluminum chloride), and organic tin compounds (such as dioctyl tin oxide, other alkyl tin, and alkyl tin oxide). One of these curing accelerators may be used alone, or two or more of them may be used in combination. Among these, the curing accelerator is preferably an imidazole, for promoting the curing reaction, further preferably triphenylimidazole for further improving the glass transition temperature (Tg) of a cured product to be obtained.

[Solvent]

The thermosetting composition of this embodiment may further contain a solvent. When the thermosetting composition of this embodiment contains a solvent, there is a tendency that the viscosity is reduced during preparation of the thermosetting composition, the handleability (handling property) is further improved, and the property of impregnation of the base material is further improved.

The solvent is not specifically limited, as long as organic resins in the thermosetting composition can be partially or fully dissolved therein, but example thereof include ketones (acetone, methyl ethyl ketone, and methyl cellosolve), aromatic hydrocarbons (such as toluene and xylene), amides (such as dimethylformaldehyde), propylene glycol monomethyl ether, and acetates thereof. One of these solvents may be used alone, or two or more of them may be used in combination.

The method for producing the thermosetting composition of this embodiment is not specifically limited, and examples thereof include a method of compounding the components collectively or sequentially in the solvent, followed by stirring. At this time, a known process such as stirring, mixing, and kneading can be used, in order to uniformly dissolving or dispersing the components.

[Applications]

Since the thermosetting composition of this embodiment can reduce warpage (package warpage) during the production of electronic components (packages), as described above, the thermosetting composition of this embodiment is used for prepregs, laminates, metal foil-clad laminates, printed wiring boards, and multilayer printed wiring boards. Since the problem of warpage is particularly remarkable in multilayer coreless boards, the thermosetting composition

of this embodiment is suitably used for multilayer coreless boards.

[Prepreg]

The prepreg of this embodiment contains a base material and the thermosetting composition of this embodiment with which the base material is impregnated or coated. As described above, the prepreg may be a prepreg to be obtained by a known method, specifically, a prepreg obtained by impregnating or coating the base material with the thermosetting composition of this embodiment, followed by heat-drying at 100 to 200°C for semi-curing (into B stage).
The prepreg of this embodiment includes a form of a cured product to be obtained by thermosetting the semicured prepreg at a heating temperature of 200 to 230°C for a heating time of 60 to 180 minutes.
The content of the thermosetting composition in the prepreg is preferably 30 to 90 vol%, more preferably 35 to 85 vol%, further preferably 40 to 80 vol%, based on the total amount of the prepreg, in terms of solids. When the content of the thermosetting composition falls within the aforementioned range, the formability tends to be further improved. The solids of the prepreg refer to the components of the prepreg excluding solvents. Fillers are included in the solids of the prepreg, for example.

(Base material)

The base material is not specifically limited, and examples thereof include known base materials used for materials of various printed wiring boards. Specific examples of the base material include glass base materials, inorganic base materials other than glass (such as inorganic base materials composed of inorganic fibers other than glass such as quartz), and organic base materials (such as organic base materials composed of organic fibers such as fully aromatic polyamide, polyester, polyparaphenylene benzoxazole, and polyimide). One of these base materials may be used alone, or two or more of them may be used in combination. Among these, glass base materials are preferable for further improving the rigidity and further excellent heating dimensional stability.

(Glass base material)

Examples of fibers constituting such a glass base material include E glass, D glass, S glass, T glass, Q glass, L glass, NE glass, and HME glass. Among these, fibers constituting the glass base material are preferably one or more fibers selected from the group consisting of E glass, D glass, S glass, T glass, Q glass, L glass, NE glass, and HME glass, from the viewpoint of being further excellent in strength and low water absorption properties.
The form of the base material is not specifically limited, but example thereof include forms such as woven fabrics, non-woven fabrics, rovings, chopped strand mats, and surfacing mats. The method for weaving woven fabrics is not specifically limited, but plain weave, nanako weave, twill weave, and the like are known, and a method can be appropriately selected from these known methods for use depending on the intended application and performance. Further, glass woven fabrics subjected to fiber opening or surface treatment using a silane coupling agent or the like are suitably used. The thickness and mass of the base material are not specifically limited, but a about 0.01 to 0.3 mm base material is generally suitably used.

[Laminate]

The laminate of this embodiment has the prepreg of this embodiment. The laminate of this embodiment contains one or a plurality of such prepregs. When the laminate contains the plurality of prepregs, the prepregs are laminated. The laminate of this embodiment has sufficiently reduced warpage (particularly, package warpage) by having the prepreg of this embodiment.

[Metal foil-clad laminate]

The metal foil-clad laminate of this embodiment contains the prepreg of this embodiment and a metal foil disposed on one or each of both surfaces of the prepreg. The metal foil-clad laminate of this embodiment contains one or a plurality of such prepregs. When the metal foil-clad laminate contains one prepreg, a metal foil is disposed on one or each of both surfaces of the prepreg. When the metal foil-clad laminate contains a plurality of prepregs, a metal foil is disposed one or each of both surfaces of laminated prepregs (laminated body of the prepregs). The metal foil-clad laminate of this embodiment has sufficiently reduced warpage (particularly, package warpage) by having the prepreg of this embodiment.
The metal foil (conductor layer) may be a metal foil used for various printed wiring board materials, and examples thereof include metal foils such as copper and aluminum. Examples of the copper metal foils include copper foils such

as rolled copper foils and electrodeposited copper foils. The thickness of the conductor layer is, for example, 1 to 70 μm, preferably 1.5 to 35 μm.

The method and conditions for forming the laminate and the metal foil-clad laminate are not specifically limited, and techniques and conditions generally used for laminates and multilayer boards for printed wiring boards can be applied. For example, when forming the laminate or the metal foil-clad laminate, a multi-stage press machine, a multi-stage vacuum press machine, a continuous forming machine, an autoclave forming machine, or the like can be used. In general, the temperature is in the range of 100 to 300°C, the pressure is in the range of a surface pressure of 2 to 100 kgf/cm$^2$, and the heating time is in the range of 0.05 to 5 hours, when forming the laminate or metal foil-clad laminate (in laminate formation). Further, it is also possible to perform post-curing at a temperature of 150 to 300°C, if necessary. Particularly when a multi-stage press machine is used, it is preferable that the temperature be 200°C to 250°C, the pressure be 10 to 40 kgf/cm$^2$, and the heating time be 80 minutes to 130 minutes, and it is more preferable that the temperature be 215°C to 235°C, the pressure be 25 to 35 kgf/cm$^2$, and the heating time be 90 minutes to 120 minutes, for sufficiently promoting the curing of the prepreg. It is also possible to form a multilayer board by laminate formation combining the prepreg with a circuit board for inner layer that is separately created.

[Printed wiring board]

The printed wiring board of this embodiment has an insulating layer formed using the prepreg of this embodiment and a conductor layer formed on a surface of the insulating layer. The printed wiring board of this embodiment can be formed, for example, by etching the metal foil of the metal foil-clad laminate of this embodiment into a predetermined wiring pattern to form a conductor layer. The printed wiring board of this embodiment has sufficiently reduced warpage (particularly, package warpage) by having the prepreg of this embodiment.

The printed wiring board of this embodiment can be specifically produced by the following method, for example. First, the metal foil-clad laminate of this embodiment is prepared. The metal foil of the metal foil-clad laminate is etched into a predetermined wiring pattern to create an inner layer board having a conductor layer (inner layer circuit). Next, a predetermined number of prepregs and a metal foil for an outer layer circuit are laminated in this order on a surface of the conductor layer (interior circuit) of the inner layer board, followed by heating and pressurizing for integral formation (laminate formation), to obtain a laminated body. The method and the conditions for laminate formation are the same as those in laminate formation of the laminate and the metal foil-clad laminate described above. Next, the laminated body is drilled to form through-holes and via holes, and a plating metal film for conducting each conductor layer (interior circuit) to a metal foil for an outer layer circuit is formed on the wall surfaces of the holes thus formed. Next, the metal foil for an outer layer circuit is etched into a predetermined wiring pattern to create an outer layer board having the conductor layer (outer layer circuit). Thus, a printed wiring board is produced.

Further, when the metal foil-clad laminate is not used, a conductor layer to serve as a circuit may be formed on the prepreg to produce a printed wiring board. At this time, a technique of electroless plating can be used for forming the conductor layer.

[Multilayer printed wiring board (multilayer coreless board)]

The multilayer printed wiring board of this embodiment includes a plurality of insulating layers composed of a first insulating layer and one or a plurality of second insulating layers laminated on one side of the first insulating layer, and a plurality of conductor layers composed of a first conductor layer disposed between each two of the plurality of insulating layers and a second conductor layers disposed on each of the surfaces of the outermost layers of the plurality of insulating layers, wherein each of the first insulating layer and the second insulating layers contains a cured product of the prepreg of this embodiment. Figure 9 shows a specific example of the multilayer printed wiring board of this embodiment. The multilayer printed wiring board shown in Figure 9 includes a first insulating layer (1) and two second insulating layers (2) laminated in one surface direction (the bottom surface direction in the figure) of the first insulating layer (1), wherein each of the first insulating layer (1) and the two second insulating layers (2) is formed using one piece of the prepreg of this embodiment. Further, the multilayer printed wiring board shown in Figure 9 has a plurality of conductor layers composed of a first conductor layer (3) disposed between each two of the plurality of insulating layers (1 and 2) and a second conductor layer (3) disposed on each of the outermost layers of the plurality of insulating layers (1 and 2).

The multilayer printed wiring board of this embodiment is, for example, a so-called coreless multilayer printed wiring board (multilayer coreless board) in which second insulating layers are laminated only in one surface direction of the first insulating layer. In such a multilayer coreless board, the problem of board warpage is generally remarkable because only in one surface direction of an insulating layer formed using a prepreg, other insulating layers formed using other prepregs are laminated. In contrast, the multilayer printed wiring board of this embodiment has sufficiently reduced warpage by each insulating layer having the prepreg of this embodiment. Further, it is possible to reduce warpage

(package warpage) during the production of electronic components (packages). Therefore, the thermosetting composition of this embodiment can sufficiently reduce the aforementioned warpage (can achieve low warpage) in multilayer coreless boards and therefore can be used effectively as a multilayer coreless board for semiconductor packages.

The method described in Examples of the present application can be, for example, referred to for the method for producing the multilayer printed wiring board of this embodiment.

Examples

Hereinafter, the present invention will be further described with reference to Examples and Comparative Examples, but the present invention is not limited by these examples at all.

[Example 1]

33 parts by mass of a phenolic compound (bisphenol A, available from Tokyo Chemical Industry Co., Ltd.), 10 parts by mass of an epoxy compound ("EPICLON HP-4710", available from DIC Corporation), 57 parts by mass of an epoxy compound ("EPICLON HP-6000", available from DIC Corporation), 100 parts by mass of a slurry silica X ("SC2050-MB", available from Admatechs Company Limited, with an average particle size of 0.7 μm), 100 parts by mass of a slurry silica Y ("SC5050-MOB", available from Admatechs Company Limited, with an average particle size of 1.5 μm), 1 part by mass of a wetting and dispersing agent X ("DISPERBYK-161", available from BYK Japan KK), 1 part by mass of a wetting and dispersing agent Y ("DISPERBYK-111", available from BYK Japan KK), 5 parts by mass of a silane coupling agent X ("KBM-403", available from Shin-Etsu Chemical Co., Ltd.), and 0.5 parts by mass of 2,4,5-triphenylimidazole (available from Tokyo Chemical Industry Co., Ltd.) were compounded (mixed), and then the mixture was diluted with methyl ethyl ketone, to obtain a varnish (thermosetting composition). In this example, the content of the bifunctional epoxy compound was 26.0 parts by mass per 100 parts by mass of the solids of the thermosetting composition, the content of the polyfunctional epoxy compound was 36.3 parts by mass per 100 parts by mass of the solids of the thermosetting composition, and the content of the bifunctional phenolic compound was 30.7 parts by mass per 100 parts by mass of the solids of the thermosetting composition. The total content of bifunctional thermosetting compounds was 56.7 parts by mass per 100 parts by mass of the solids of the thermosetting composition, and the total content of polyfunctional thermosetting compounds was 36.3 parts by mass per 100 parts by mass of the solids of the thermosetting composition. An E glass woven fabric (IPC#1280) was impregnated and coated with this varnish (thermosetting composition), followed by heat-drying at 150°C for 3 minutes, to obtain a prepreg with a thickness of about 80 μm. The content of the thermosetting composition (solids (including fillers)) in the prepreg obtained was 73 vol%.

The proportions of bifunctional thermosetting compounds and polyfunctional thermosetting compounds in each compound were determined by gel permeation chromatography (GPC) under the following conditions. That is, a detector RID-10A was connected to a pump LC-20AD, available from SHIMADZU CORPORATION, and columns Shodex GPC KF-801, KF-802, KF-803, and KF-804, available from Showa Denko K.K., were connected thereto and used at a column temperature of 40°C. Tetrahydrofuran was used as a mobile phase at a flow rate of 1.0 mL/min. Each compound was adjusted to a 5% tetrahydrofuran solution, and 20 μL of the solution was applied to a measuring instrument, so that the proportions of bifunctional compounds and polyfunctional compounds contained in each compound were determined from their peak areas.

[Example 2]

A prepreg with a thickness of about 80 μm was obtained in the same manner as in Example 1 except that the amount of the slurry silica X mixed was changed from 100 parts by mass to 50 parts by mass, and the amount of the slurry silica Y mixed was changed from 100 parts by mass to 50 parts by mass. In this example, the content of the bifunctional epoxy compound was 26.0 parts by mass per 100 parts by mass of the solids of the thermosetting composition, the content of the polyfunctional epoxy compound was 36.3 parts by mass per 100 parts by mass of the solids of the thermosetting composition, and the content of the bifunctional phenolic compound was 30.7 parts by mass per 100 parts by mass of the solids of the thermosetting composition. The total content of bifunctional thermosetting compounds was 56.7 parts by mass per 100 parts by mass of the solids of the thermosetting composition, and the total content of polyfunctional thermosetting compounds was 36.3 parts by mass per 100 parts by mass of the solids of the thermosetting composition. The content of the thermosetting composition in the prepreg obtained was 73 vol%.

[Example 3]

A prepreg with a thickness of about 80 μm was obtained in the same manner as in Example 1 except that the amount of the slurry silica X mixed was changed from 100 parts by mass to 25 parts by mass, and the amount of the

slurry silica Y mixed was changed from 100 parts by mass to 25 parts by mass. In this example, the content of the bifunctional epoxy compound was 26.0 parts by mass per 100 parts by mass of the solids of the thermosetting composition, the content of the polyfunctional epoxy compound was 36.3 parts by mass per 100 parts by mass of the solids of the thermosetting composition, and the content of the bifunctional phenolic compound was 30.7 parts by mass per 100 parts by mass of the solids of the thermosetting composition. The total content of bifunctional thermosetting compounds was 56.7 parts by mass per 100 parts by mass of the solids of the thermosetting composition, and the total content of polyfunctional thermosetting compounds was 36.3 parts by mass per 100 parts by mass of the solids of the thermosetting composition. The content of the thermosetting composition in the prepreg obtained was 73 vol%.

[Example 4]

A prepreg with a thickness of about 100 μm was obtained in the same manner as in Example 1 except that an E glass woven fabric (IPC#2116) was used instead of the E glass woven fabric (IPC#1280). In this example, the content of the bifunctional epoxy compound was 26.0 parts by mass per 100 parts by mass of the solids of the thermosetting composition, the content of the polyfunctional epoxy compound was 36.3 parts by mass per 100 parts by mass of the solids of the thermosetting composition, and the content of the bifunctional phenolic compound was 30.7 parts by mass per 100 parts by mass of the solids of the thermosetting composition. The total content of bifunctional thermosetting compounds was 56.7 parts by mass per 100 parts by mass of the solids of the thermosetting composition, and the total content of polyfunctional thermosetting compounds was 36.3 parts by mass per 100 parts by mass of the solids of the thermosetting composition. The content of the thermosetting composition in the prepreg obtained was 58 vol%.

[Example 5]

A prepreg with a thickness of about 80 μm was obtained in the same manner as in Example 2 except that 57 parts by mass of an epoxy compound ("EPICLON HP-7200L", available from DIC Corporation) was mixed instead of 57 parts by mass of the epoxy compound ("EPICLON HP-6000", available from DIC Corporation), and the wetting and dispersing agent X was not used. In this example, the content of the bifunctional epoxy compound was 35.3 parts by mass per 100 parts by mass of the solids of the thermosetting composition, the content of the polyfunctional epoxy compound was 27.6 parts by mass per 100 parts by mass of the solids of the thermosetting composition, and the content of the bifunctional phenolic compound was 31.0 parts by mass per 100 parts by mass of the solids of the thermosetting composition. The total content of bifunctional thermosetting compounds was 66.3 parts by mass per 100 parts by mass of the solids of the thermosetting composition, and the total content of polyfunctional thermosetting compounds was 27.6 parts by mass per 100 parts by mass of the solids of the thermosetting composition. The content of the thermosetting composition in the prepreg obtained was 73 vol%.

[Example 6]

A prepreg with a thickness of about 80 μm was obtained in the same manner as in Example 2 except that the amount of the phenolic compound (bisphenol A, available from Tokyo Chemical Industry Co., Ltd.) mixed was changed from 33 parts by mass to 32 parts by mass, the amount of the epoxy compound ("EPICLON HP-4710", available from DIC Corporation) mixed was changed from 10 parts by mass to 5 parts by mass, 63 parts by mass of an epoxy compound ("EPICLON HP-7200L", available from DIC Corporation) was used instead of 57 parts by mass of the epoxy compound ("EPICLON HP-6000", available from DIC Corporation), and the wetting and dispersing agent X was not used. In this example, the content of the bifunctional epoxy compound was 39.0 parts by mass per 100 parts by mass of the solids of the thermosetting composition, the content of the polyfunctional epoxy compound was 24.8 parts by mass per 100 parts by mass of the solids of the thermosetting composition, and the content of the bifunctional phenolic compound was 30.0 parts by mass per 100 parts by mass of the solids of the thermosetting composition. The total content of bifunctional thermosetting compounds was 69.1 parts by mass per 100 parts by mass of the solids of the thermosetting composition, and the total content of polyfunctional thermosetting compounds was 24.8 parts by mass per 100 parts by mass of the solids of the thermosetting composition. The content of the thermosetting composition in the prepreg obtained was 73 vol%.

[Example 7]

A prepreg with a thickness of about 80 μm was obtained in the same manner as in Example 1 except that 45 parts by mass of a phenolic compound ("BCF (biscresol fluorene)", available from Osaka Gas Chemicals Co., Ltd.) was mixed instead of 33 parts by mass of the phenolic compound (bisphenol A, available from Tokyo Chemical Industry Co., Ltd.), the amount of the epoxy compound ("EPICLON HP-6000", available from DIC Corporation) mixed was changed

from 57 parts by mass to 45 parts by mass, and the wetting and dispersing agent X was not used. In this example, the content of the bifunctional epoxy compound was 20.7 parts by mass per 100 parts by mass of the solids of the thermosetting composition, the content of the polyfunctional epoxy compound was 30.9 parts by mass per 100 parts by mass of the solids of the thermosetting composition, and the content of the bifunctional phenolic compound was 42.3 parts by mass per 100 parts by mass of the solids of the thermosetting composition. The total content of bifunctional thermosetting compounds was 63.0 parts by mass per 100 parts by mass of the solids of the thermosetting composition, and the total content of polyfunctional thermosetting compounds was 30.9 parts by mass per 100 parts by mass of the solids of the thermosetting composition. The content of the thermosetting composition in the prepreg obtained was 73 vol%.

[Example 8]

A prepreg with a thickness of about 80 μm was obtained in the same manner as in Example 1 except that 43 parts by mass of a phenolic compound (bisphenol M, available from Mitsui Fine Chemicals, Inc.) was mixed instead of 33 parts by mass of the phenolic compound (bisphenol A, available from Tokyo Chemical Industry Co., Ltd.), and the amount of the epoxy compound ("EPICLON HP-6000", available from DIC Corporation) mixed was changed from 57 parts by mass to 47 parts by mass. In this example, the content of the bifunctional epoxy compound was 21.4 parts by mass per 100 parts by mass of the solids of the thermosetting composition, the content of the polyfunctional epoxy compound was 31.6 parts by mass per 100 parts by mass of the solids of the thermosetting composition, and the content of the bifunctional phenolic compound was 40.0 parts by mass per 100 parts by mass of the solids of the thermosetting composition. The total content of bifunctional thermosetting compounds was 61.4 parts by mass per 100 parts by mass of the solids of the thermosetting composition, and the total content of polyfunctional thermosetting compounds was 31.6 parts by mass per 100 parts by mass of the solids of the thermosetting composition. The content of the thermosetting composition in the prepreg obtained was 73 vol%.

[Comparative Example 1]

10 parts by mass of an epoxy compound ("EPICLON HP-7200L", available from DIC Corporation), 18 parts by mass of a polyphenylmethane maleimide compound ("BMI-2300", available from Daiwa Kasei Industry Co., Ltd.), 18 parts by mass of a biphenylaralkyl-type phenolic resin ("KAYAHARD GPH-103", available from Nippon Kayaku Co., Ltd.), 15 parts by mass of a phenol-modified xylene compound ("XYSTAR GP100", available from Fudow Company Limited), 39 parts by mass of a biphenylaralkyl-type epoxy compound ("NC-3000H", available from Nippon Kayaku Co., Ltd.), 100 parts by mass of a slurry silica X, 100 parts by mass of a slurry silica Y, 1 part by mass of a wetting and dispersing agent X, 1 part by mass of a wetting and dispersing agent Y, 5 parts by mass of a silane coupling agent X, and 0.5 parts by mass of 2,4,5-triphenylimidazole (available from Tokyo Chemical Industry Co., Ltd.) were compounded (mixed), and then the mixture was diluted with methyl ethyl ketone, to obtain a varnish (thermosetting composition). An E glass woven fabric (IPC#1280) was impregnated and coated with this varnish (thermosetting composition), followed by heat-drying at 150°C for 3 minutes, to obtain a prepreg with a thickness of about 80 μm. In this example, the content of the bifunctional epoxy compound was 17.0 parts by mass per 100 parts by mass of the solids of the thermosetting composition, the content of the polyfunctional epoxy compound was 28.6 parts by mass per 100 parts by mass of the solids of the thermosetting composition, and the content of the bifunctional phenolic compound was 6.3 parts by mass per 100 parts by mass of the solids of the thermosetting composition. The total content of bifunctional thermosetting compounds was 33.0 parts by mass per 100 parts by mass of the solids of the thermosetting composition, and the total content of polyfunctional thermosetting compounds was 60.0 parts by mass per 100 parts by mass of the solids of the thermosetting composition. The content of the thermosetting composition (solids) in the prepreg obtained was 73 vol%.

[Comparative Example 2]

A prepreg with a thickness of about 80 μm was obtained in the same manner as in Comparative Example 1 except that the amount of the slurry silica X mixed was changed from 100 parts by mass to 50 parts by mass, and the amount of the slurry silica Y mixed was changed from 100 parts by mass to 50 parts by mass. In this example, the content of the bifunctional epoxy compound was 17.0 parts by mass per 100 parts by mass of the solids of the thermosetting composition, the content of the polyfunctional epoxy compound was 28.6 parts by mass per 100 parts by mass of the solids of the thermosetting composition, and the content of the bifunctional phenolic compound was 6.3 parts by mass per 100 parts by mass of the solids of the thermosetting composition. The total content of bifunctional thermosetting compounds was 33.0 parts by mass per 100 parts by mass of the solids of the thermosetting composition, and the total content of polyfunctional thermosetting compounds was 60.0 parts by mass per 100 parts by mass of the solids of the thermosetting composition. The content of the thermosetting composition in the prepreg obtained was 73 vol%.

[Comparative Example 3]

A prepreg with a thickness of about 80 μm was obtained in the same manner as in Comparative Example 1 except that the amount of the slurry silica X mixed was changed from 100 parts by mass to 25 parts by mass, and the amount of the slurry silica Y mixed was changed from 100 parts by mass to 25 parts by mass. In this example, the content of the bifunctional epoxy compound was 17.0 parts by mass per 100 parts by mass of the solids of the thermosetting composition, the content of the polyfunctional epoxy compound was 28.6 parts by mass per 100 parts by mass of the solids of the thermosetting composition, and the content of the bifunctional phenolic compound was 6.3 parts by mass per 100 parts by mass of the solids of the thermosetting composition. The total content of bifunctional thermosetting compounds was 33.0 parts by mass per 100 parts by mass of the solids of the thermosetting composition, and the total content of polyfunctional thermosetting compounds was 60.0 parts by mass per 100 parts by mass of the solids of the thermosetting composition. The content of the thermosetting composition in the prepreg obtained was 73 vol%.

[Comparative Example 4]

A prepreg with a thickness of about 100 μm was obtained in the same manner as in Comparative Example 1 except that an E glass woven fabric (IPC#2116) was used instead of the E glass woven fabric (IPC#1280). In this example, the content of the bifunctional epoxy compound was 17.0 parts by mass per 100 parts by mass of the solids of the thermosetting composition, the content of the polyfunctional epoxy compound was 28.6 parts by mass per 100 parts by mass of the solids of the thermosetting composition, and the content of the bifunctional phenolic compound was 6.3 parts by mass per 100 parts by mass of the solids of the thermosetting composition. The total content of bifunctional thermosetting compounds was 33.0 parts by mass per 100 parts by mass of the solids of the thermosetting composition, and the total content of polyfunctional thermosetting compounds was 60.0 parts by mass per 100 parts by mass of the solids of the thermosetting composition. The content of the thermosetting composition in the prepreg obtained was 58 vol%.

[Measurement and evaluation of physical properties]

Using the prepreg obtained in each of Examples 1 to 8 and Comparative Examples 1 to 4, a sample for measuring and evaluating the physical properties was produced by the procedure shown below in each item, to measure and evaluate the mechanical properties (the storage moduli at 30°C, 100°C, 200°C, 260°C, and 330°C), the coefficient of thermal expansion (CTE), the glass transition temperature (Tg), the loss factor (tanΔ), the amount of warpage, and the water absorption heat resistance. Table 1 collectively shows the results of Examples and Comparative Examples. In the table, E' (30) represents a (the storage modulus at 30°C), E' (100) represents b (the storage modulus at 100°C), E' (200) represents d (the storage modulus at 200°C), E' (260) represents c (the storage modulus at 260°C), and E' (330) represents e (the storage modulus at 330°C). Further, tanΔ in the table represents D (the loss tangent of the elastic modulus at the glass transition temperature of a cured product obtained by curing the prepreg).

[Mechanical properties and glass transition temperature]

A copper foil ("3EC-VLP", available from MITSUI MINING & SMELTING CO.,LTD., with a thickness of 12 μm) was disposed on each of both top and bottom surfaces of one piece of the prepreg obtained in each of Examples 1 to 8 and Comparative Examples 1 to 4, followed by laminate formation (thermosetting) at a pressure of 30 $kgf/cm^2$ and a temperature of 220°C for 100 minutes, to obtain a copper foil-clad laminate having the copper foils and an insulating layer formed using the prepreg. The insulating layer of the copper foil-clad laminate had a thickness of about 80 to 100 μm. After the copper foil-clad laminate obtained was cut into a size of 5.0 mm × 20 mm using a dicing saw, the copper foils on the surfaces were removed by etching, to obtain a measurement sample. Using the measurement sample, the mechanical properties (the storage modulus E' at 30°C, 100°C, 200°C, 260°C, and 330°C), the glass transition temperature (Tg), and the loss tangent (tanΔ) at the glass transition temperature were measured (average of n = 3) by DMA using a dynamic viscoelasticity analyzer (available from TA Instruments Inc.) according to JIS C6481.

[Coefficient of thermal expansion (CTE (X and Y))]

A copper foil ("3EC-VLP", available from MITSUI MINING & SMELTING CO.,LTD., with a thickness of 12 μm) was disposed on each of both top and bottom surfaces of one piece of the prepreg obtained in each of Examples 1 to 8 and Comparative Examples 1 to 4, followed by laminate formation (thermosetting) at a pressure of 30 $kgf/cm^2$ and a temperature of 220°C for 100 minutes, to obtain a copper foil-clad laminate having the copper foils and an insulating layer formed using the prepreg. The insulating layer of the copper foil-clad laminate had a thickness of about 80 to 100

μm. After the copper foil-clad laminate obtained was cut into a size of 4.5 mm × 20 mm using a dicing saw, the copper foils on the surfaces were removed by etching, to obtain a measurement sample. Using the measurement sample, the coefficient of thermal expansion (CTE (X and Y)) in a direction orthogonal to the laminate direction of the insulating layer of the laminate was measured (average of n = 3) by TMA (Thermo-mechanical analysis) according to JIS C6481.

[Amount of warpage: Multilayer coreless board]

As shown in Figure 1 an ultra-thin copper foil provided with a carrier (b1) (MT18Ex, available from MITSUI MINING & SMELTING CO., LTD., with a thickness of 5 μm) was first disposed on each of both surfaces of the prepreg serving as a support (a) with the surface of the carrier copper foil facing the prepreg, a prepreg (c1) obtained in each of Examples 1 to 8 and Comparative Examples 1 to 4 was further disposed thereon, and a copper foil (d) (3EC-VLP, with a thickness of 12 μm) was further disposed thereon, followed by laminate formation at a pressure of 30 $kgf/cm^2$ and a temperature of 220°C for 100 minutes, to obtain a copper foil-clad laminate shown in Figure 2.

Then, the copper foil (d) of the copper foil-clad laminate obtained shown in Figure 2 was etched into a predetermined wiring pattern, for example, as shown in Figure 3, to form a conductor layer (d'). Next, a prepreg (c2) obtained in each of Examples 1 to 8 and Comparative Examples 1 to 4 was disposed on each of both surfaces of the laminate shown in Figure 3 with the conductor layer (d') formed, as shown in Figure 4, and an ultra-thin copper foil provided with a carrier (b2) (MT18Ex, with a thickness of 5 μm) was further disposed on each of the top and bottom of the laminate, followed by laminate formation at a pressure of 30 $kgf/cm^2$ and a temperature of 220°C for 100 minutes, to obtain a copper foil-clad laminate shown in Figure 5.

Then, two pieces of laminates were separated from the support (a), as shown in Figure 6, by separating the carrier copper foil and the ultra-thin copper foil of the ultra-thin copper foil provided with a carrier (b1) disposed on the support (a) (cured support prepreg) in the copper foil-clad laminate shown in Figure 5, and the carrier copper foil was further separated from the ultra-thin copper foil provided with a carrier (b2) on the top of each laminate. Next, the ultra-thin copper foil on each of the top and bottom of the laminate obtained was processed using a laser instrument, to form predetermined vias (v) by chemical copper plating, as shown in Figure 7. Then, it was etched into a predetermined wiring pattern to form a conductor layer, for example, as shown in Figure 8, thereby obtaining a panel of a multilayer coreless board (size: 500 mm × 400 mm). Further, the amount of warpage was measured at the four corners of the panel obtained using a scale, and the average thereof was taken as the "amount of warpage" of the panel of the multilayer coreless board (average of n = 2).

[Amount of warpage (package warpage)]

Further, a 20 mm × 200 mm strip-shaped plate was cut out from the panel of the multilayer coreless board obtained (copper foil-clad laminate in Figure 8). Subsequently, a liquid underfill (2274E, available from ThreeBond Holdings Co., Ltd.) was applied thereto, then a semiconductor device (with a size of 10 mm × 10 mm and a thickness of 100 μm) was mounted thereon by adhesion, and the underfill was cured, first at a temperature of 50°C for 30 minutes, then at a temperature of 120°C for 30 minutes, and further at 150°C for 30 minutes. Subsequently, it was cut into a size of 14 mm × 14 mm, to obtain a sample for evaluating package warpage. The amount of package warpage was obtained by measuring the maximum warpage value and the minimum warpage value when heating the package sample from room temperature up to 260°C using TherMoire PS200L shadow moire analysis, available from AKROMETRIX, thereafter cooling it to room temperature, and taking the difference therebetween as an "amount of warpage" of the package (average of n = 3). Table 1 shows the relative values (vs Example 1) of Examples and Comparative Examples, regarding the measured value in Example 1 as 1.

[Moisture absorption heat resistance]

Two pieces of the prepreg obtained in each of Examples 1 to 8 and Comparative Examples 1 to 4 were stacked, and a copper foil (3EC-VLP, with a thickness of 12 μm) was disposed on each of both top and bottom surfaces, followed by laminate formation (thermosetting) at a pressure of 30 $kgf/cm^2$ and a temperature of 220°C for 100 minutes, to obtain a copper foil-clad laminate having the copper foils and insulating layers formed using the prepregs. The copper foil-clad laminate obtained was cut into a size of 50 mm × 50 mm, to obtain a measurement sample. After standing in a closed container at 120°C under saturated vapor pressure for one hour as pretreatment, the sample obtained was put into a solder bath at 260°C and immersed therein for 30 seconds, to perform evaluation. After a lapse of 30 seconds, the presence or absence of swelling in the copper foils of the sample, between the samples, and in the sample was checked. The case where no swelling occurred was defined as "A", and the case where swelling occurred was defined as "B".

[Table 1]

| | | | Example 1 | Example 2 | Example 3 | Example 4 | Example 5 | Example 6 | Example 7 | Example 8 | Comparative Example 1 | Comparative Example 2 | Comparative Example 3 | Comparative Example 4 |
|---|---|---|---|---|---|---|---|---|---|---|---|---|---|---|
| Evaluation of physical properties | Coefficient of thermal expansion | ppm/°C | 11 | 13.5 | 15 | 9 | 12 | 12.3 | 12 | 11.5 | 11 | 12.8 | 15 | 8.8 |
| | Glass transition temperature | °C | 155 | 157 | 160 | 163 | 154 | 152 | 209 | 137 | 151 | 155 | 154 | 163 |
| | Elastic modulus E'(30) | GPa | 23.8 | 18.7 | 16.8 | 30 | 23.7 | 24.4 | 20.1 | 19.2 | 22.2 | 19.8 | 16.6 | 29 |
| | Elastic modulus E'(100) | GPa | 22.4 | 17.9 | 16 | 28.9 | 22.5 | 23.5 | 18.9 | 18.2 | 21.1 | 19 | 15.9 | 28.1 |
| | Elastic modulus E'(200) | GPa | 4.2 | 4.5 | 4 | 7.8 | 4.3 | 4.5 | 12.7 | 4.6 | 9.8 | 9.1 | 7.3 | 13.9 |
| | Elastic modulus E'(260) | GPa | 2.6 | 3.1 | 2.8 | 5.4 | 2.6 | 3.2 | 5.4 | 3.2 | 7.8 | 7.2 | 5.8 | 10.1 |
| | Elastic modulus E'(330) | GPa | 2.3 | 2.8 | 2.6 | 4.6 | 2.5 | 2.8 | 4.4 | 3 | 7.8 | 7.2 | 5.8 | 9.1 |
| | Loss factor | tanΔ | 0.18 | 0.16 | 0.15 | 0.17 | 0.16 | 0.19 | 0.14 | 0.12 | 0.06 | 0.06 | 0.07 | 0.07 |
| | E'(100)/E'(30) | | 0.94 | 0.96 | 0.95 | 0.96 | 0.95 | 0.96 | 0.94 | 0.95 | 0.95 | 0.96 | 0.96 | 0.97 |
| | E'(200)/E'(30) | | 0.18 | 0.24 | 0.24 | 0.26 | 0.18 | 0.18 | 0.63 | 0.24 | 0.44 | 0.46 | 0.44 | 0.48 |
| | E'(260)/E'(30) | | 0.11 | 0.17 | 0.17 | 0.18 | 0.11 | 0.13 | 0.27 | 0.17 | 0.35 | 0.36 | 0.35 | 0.35 |
| | E'(330)/E'(30) | | 0.1 | 0.15 | 0.15 | 0.15 | 0.11 | 0.11 | 0.22 | 0.16 | 0.35 | 0.36 | 0.35 | 0.31 |
| | Amount of warpage | Multilayer coreless board [mm] | 1.1 | - | - | - | - | - | - | - | 1.6 | - | - | - |
| | | Package [index] | 1 | 1 | 1 | 0.7 | 1 | 1 | 1 | 1 | 1.4 | 1.4 | 1.5 | 0.9 |
| | Water absorption heat resistance | | A | A | A | A | A | B | A | A | A | A | A | A |

Although it is effective for reducing the package warpage to reduce the coefficient of thermal expansion in the plane direction of the printed wiring board, as described above, there is a limit in reducing package warpage, even if the coefficient of thermal expansion is reduced, as in Comparative Examples 1 to 3. In contrast, for example, as is obvious from the comparison between Example 1 and Comparative Example 1 of the present application, package warpage can be significantly reduced in Examples of the present application, despite the same coefficient of thermal expansion, by the parameters of the physical properties defined by the storage moduli at predetermined temperatures falling within predetermined ranges. Further, as in Example 3, even if the coefficient of thermal expansion is not reduced, package warpage can be significantly reduced by the parameters of the physical properties defined by the storage moduli at predetermined temperatures falling within predetermined ranges.

Further, as a result of comparing Example 4 with Comparative Example 4 with the same content of the thermosetting composition (solids) in each prepreg, the amount of warpage was reduced more in Example 4 that satisfies formulas (i) and (ii) above, as compared with Comparative Example 4 that does not satisfy formula (ii) above.

The present application is based on the Japanese patent application (Japanese Patent Application No. 2018-081070) filed with the Japan Patent Office on April 20, 2018, the contents of which are incorporated herein by reference.

## Claims

1. A thermosetting composition comprising at least a thermosetting compound,
the thermosetting composition satisfying relationships represented by formulas (i) and (ii) below:

$$0.80 \leq b/a \leq 0.98 \cdots \text{(i)},$$

and

$$0.05 \leq c/a \leq 0.30 \cdots \text{(ii)},$$

wherein a, b, and c represent storage moduli (unit: GPa) at 30°C, 100°C, and 260°C, respectively, of a cured product formed by curing a prepreg obtained by impregnating or coating a base material with the thermosetting composition.

2. The thermosetting composition according to claim 1, further satisfying a relationship represented by formula (x) below:

$$100 \leq Tg \leq 220 \cdots \text{(x)},$$

wherein Tg represents a glass transition temperature (unit: °C) of a cured product formed by curing a prepreg obtained by impregnating or coating a base material with the thermosetting composition.

3. The thermosetting composition according to claim 1 or 2, further satisfying a relationship represented by formula (y) below:

$$D \geq 0.1 \cdots \text{(y)},$$

wherein D represents a loss tangent of an elastic modulus at a glass transition temperature of a cured product formed by curing a prepreg obtained by impregnating or coating a base material with the thermosetting composition.

4. The thermosetting composition according to any one of claims 1 to 3, wherein
the thermosetting compound comprises a bifunctional thermosetting compound having bifunctionality and a polyfunctional thermosetting compound having tri- or higher functionality,
a content of the bifunctional thermosetting compound is 40 to 90 parts by mass per 100 parts by mass of the solids of the thermosetting composition, and
a content of the polyfunctional thermosetting compound is 10 to 50 parts by mass per 100 parts by mass of the solids of the thermosetting composition.

5. The thermosetting composition according to any one of claims 1 to 3, wherein
the thermosetting compound comprises a bifunctional epoxy compound and a polyfunctional epoxy compound,
a content of the bifunctional epoxy compound is 20 to 70 parts by mass per 100 parts by mass of the solids of the thermosetting composition, and
a content of the polyfunctional epoxy compound is 10 to 50 parts by mass per 100 parts by mass of the solids of the thermosetting composition.

6. The thermosetting composition according to claim 5, wherein
at least one of the bifunctional epoxy compound and the polyfunctional epoxy compound comprises a naphthalene-type epoxy resin.

7. The thermosetting composition according to any one of claims 1 to 6, wherein
the thermosetting compound comprises a phenolic compound.

8. The thermosetting composition according to claim 7, wherein
the phenolic compound comprises a bifunctional phenolic compound, and
a content of the bifunctional phenolic compound is 20 to 60 parts by mass per 100 parts by mass of the solids of the thermosetting composition.

9. The thermosetting composition according to any one of claims 1 to 8, further comprising
an inorganic filler, wherein
a content of the inorganic filler is 30 parts by mass or more and 700 parts by mass or less per 100 parts by mass of the solids of the thermosetting composition.

10. The thermosetting composition according to claim 9, wherein
the inorganic filler is one or more selected from the group consisting of silica, boehmite, and alumina.

11. The thermosetting composition according to any one of claims 1 to 10 for use in a metal foil-clad laminate.

12. The thermosetting composition according to any one of claims 1 to 10 for use in a printed wiring board.

13. The thermosetting composition according to any one of claims 1 to 10 for use in a multilayer printed wiring board.

14. A prepreg comprising:

a base material; and
the thermosetting composition according to any one of claims 1 to 13, with which the base material is impregnated or coated.

15. The prepreg according to claim 14, wherein
the base material is composed of one or more glass fibers selected from the group consisting of E glass, D glass, S glass, T glass, Q glass, L glass, NE glass, and HME glass.

16. A laminate comprising the prepreg according to claim 14 or 15.

17. A metal foil-clad laminate comprising:

the prepreg according to claim 14 or 15; and
a metal foil disposed on one or each of both surfaces of the prepreg.

18. A printed wiring board comprising:

an insulating layer formed using the prepreg according to claim 14 or 15; and
a conductor layer formed on a surface of the insulating layer.

19. A multilayer printed wiring board comprising:

a plurality of insulating layers composed of a first insulating layer and one or a plurality of second insulating

layers laminated on one side of the first insulating layer; and

a plurality of conductor layers composed of a first conductor layer disposed between each two of the plurality of insulating layers and a second conductor layer disposed on each of surfaces of outermost layers of the plurality of insulating layers, wherein

the first insulating layer and the second insulating layer each comprise a cured product of the prepreg according to claim 14 or 15.

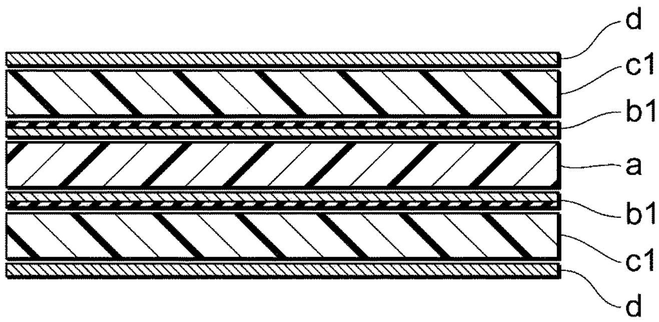


Fig.1

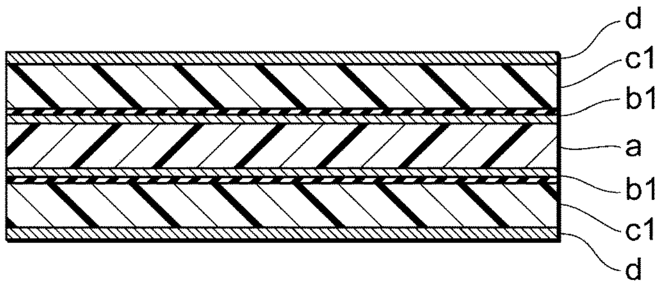


Fig.2

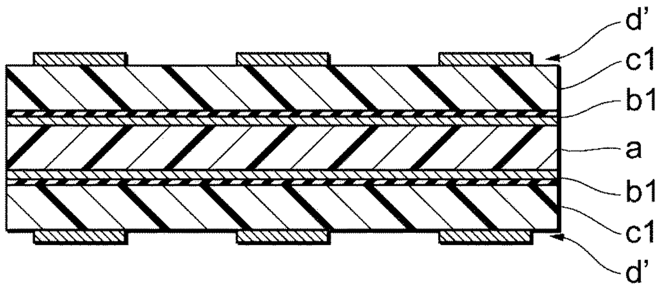


Fig.3

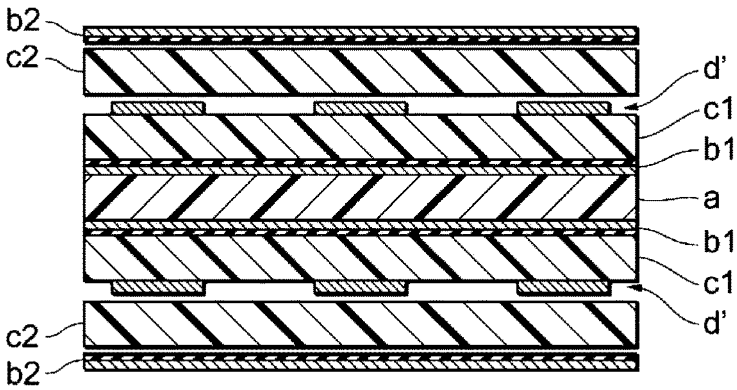


Fig.4

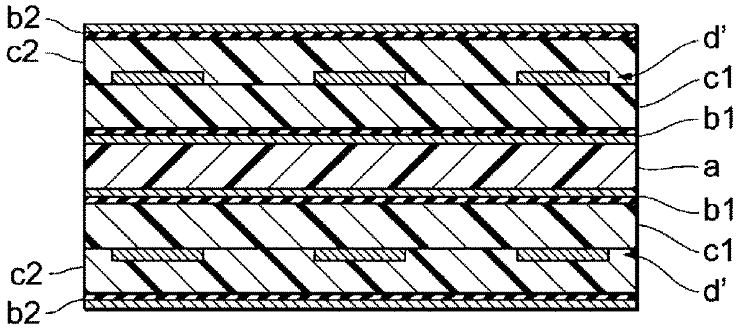


Fig.5

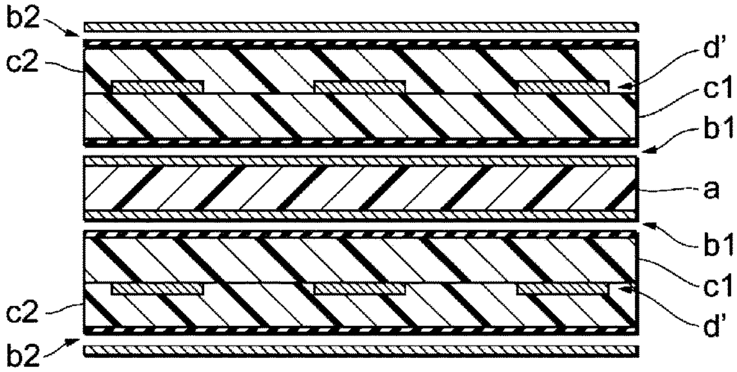


Fig.6

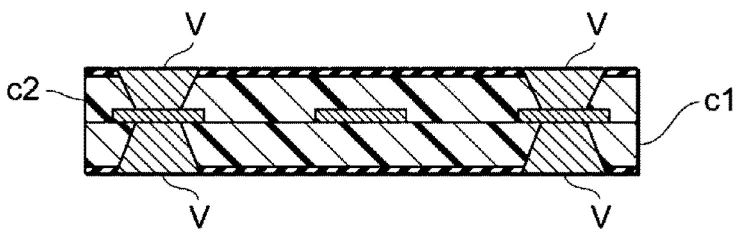


Fig.7

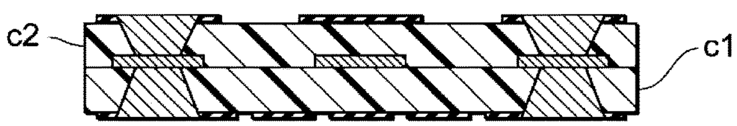


Fig.8

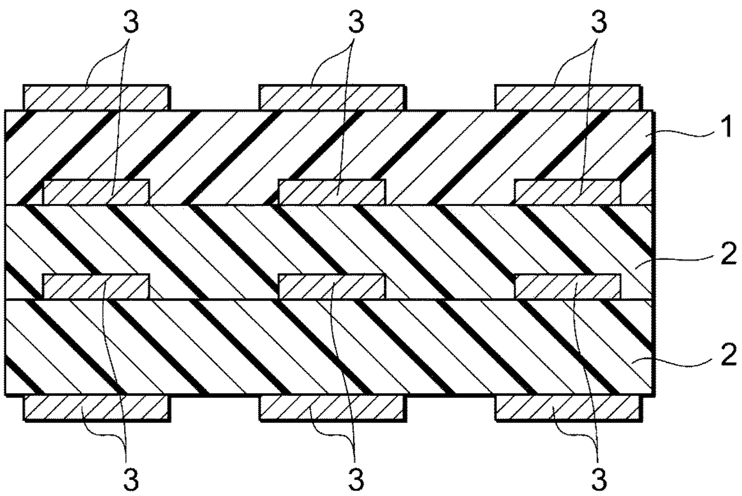


Fig.9

**INTERNATIONAL SEARCH REPORT**

International application No.
PCT/JP2019/016553

A. CLASSIFICATION OF SUBJECT MATTER
Int.Cl. C08G59/32(2006.01)i, B32B15/092(2006.01)i, C08J5/24(2006.01)i, C08K3/013(2018.01)i, C08K5/13(2006.01)i, C08L63/00(2006.01)i, H05K1/03(2006.01)i, H05K3/46(2006.01)i
According to International Patent Classification (IPC) or to both national classification and IPC

B. FIELDS SEARCHED
Minimum documentation searched (classification system followed by classification symbols)
Int.Cl. B29B11/16, B29B15/08-15/14, C08J5/04-5/10, C08J5/24, B32B1/00-43/00, C08K3/013, C08K5/13, C08L63/00, H05K1/03, H05K3/46

Documentation searched other than minimum documentation to the extent that such documents are included in the fields searched

| | |
|---|---|
| Published examined utility model applications of Japan | 1922-1996 |
| Published unexamined utility model applications of Japan | 1971-2019 |
| Registered utility model specifications of Japan | 1996-2019 |
| Published registered utility model applications of Japan | 1994-2019 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| X | JP 5-318653 A (TOSHIBA CHEM CORP.) 03 December 1993, claim 1, paragraph [0018], example 2 (Family: none) | 1-5, 7, 9, 11, 14-17 |
| X | JP 2-86434 A (SHIN KOBE ELECTRIC MACHINERY CO., LTD.) 27 March 1990, claim 1, page 3, upper right column, line 5 to lower left column, line 1, example 2, table 1 (Family: none) | 1-5, 7-8, 11, 14-17 |

☒ Further documents are listed in the continuation of Box C. ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 04.07.2019 | 16.07.2019 |

| Name and mailing address of the ISA/ | Authorized officer |
|---|---|
| Japan Patent Office<br>3-4-3, Kasumigaseki, Chiyoda-ku,<br>Tokyo 100-8915, Japan | Telephone No. |

Form PCT/ISA/210 (second sheet) (January 2015)

**INTERNATIONAL SEARCH REPORT**

International application No.
PCT/JP2019/016553

C (Continuation). DOCUMENTS CONSIDERED TO BE RELEVANT

| Category* | Citation of document, with indication, where appropriate, of the relevant passages | Relevant to claim No. |
|---|---|---|
| X | JP 2018-500423 A (CYTEC INDUSTRIES INC.) 11 January 2018, claim 5, example 4, table 1 & US 2016/0168372 A1, claim 5, example 4, table 1 & EP 3233960 A1 & CN 107108854 A | 1-5, 14-17 |
| X | JP 2012-241179 A (PANASONIC CORPORATION) 10 December 2012, claim 1, paragraphs [0027]-[0048], [0049], [0060], [0066], [0076], [0077], example 1, table 1 (Family: none) | 1-19 |
| X | JP 2009-292866 A (MITSUBISHI RAYON CO., LTD.) 17 December 2009, paragraph [0042], examples 4, 5, tables 1, 2 (Family: none) | 1-5, 9-10, 14-15 |
| X | JP 2001-40122 A (TORAY INDUSTRIES, INC.) 13 February 2001, example 5, table 1 (Family: none) | 1-5, 14-16 |
| X | JP 2001-40121 A (TORAY INDUSTRIES, INC.) 13 February 2001, example 5, table 1 (Family: none) | 1-5, 14-16 |
| A | JP 2000-344870 A (TORAY INDUSTRIES, INC.) 12 December 2000 (Family: none) | 1-19 |
| A | JP 11-181124 A (SUMITOMO BAKELITE CO., LTD.) 06 July 1999 (Family: none) | 1-19 |
| A | JP 2002-206019 A (MITSUI CHEMICALS, INC.) 26 July 2002 & US 2003/0069356 A1 & EP 1270632 A1 & CN 1392883 A | 1-19 |
| A | JP 2001-81214 A (SHIN KOBE ELECTRIC MACHINERY CO., LTD.) 27 March 2001 (Family: none) | 1-19 |
| A | JP 2016-3335 A (SHENGYI TECHNOLOGY CO., LTD.) 12 January 2016 & CN 105237949 A & KR 10-2015-0143234 A & TW 201546163 A | 1-19 |
| A | US 2018/0100044 A1 (HEXCEL CORPORATION) 12 April 2018 & EP 3475349 A1 & CN 109563289 A | 1-19 |
| A | US 2017/0218113 A1 (SWANCOR INDUSTRIAL CO., LTD.) 03 August 2017 & CN 107022168 A & TW 201728609 A | 1-19 |

Form PCT/ISA/210 (continuation of second sheet) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2014037485 A
- JP 5056787 B
- JP 2018081070 A